(19) **Europäisches Patentamt European Patent Office Office européen des brevets**

(11) **EP 2 762 896 B1**

(12) **EUROPEAN PATENT SPECIFICATION**

(45) Date of publication and mention of the grant of the patent:
**13.11.2019 Bulletin 2019/46**

(21) Application number: **12835268.9**

(22) Date of filing: **25.09.2012**

(51) Int Cl.:
**G01Q 60/54** *(2010.01)*    **G01Q 30/04** *(2010.01)*

(86) International application number:
**PCT/JP2012/074599**

(87) International publication number:
**WO 2013/047537 (04.04.2013 Gazette 2013/14)**

(54) **DC MAGNETIC FIELD MAGNETIC PROFILE MEASURING DEVICE AND MAGNETIC PROFILE MEASURING METHOD**

GLEICHSTROM-MAGNETFELD-PROFILMESSVORRICHTUNG UND MAGNETISCHES PROFILMESSVERFAHREN

DISPOSITIF DE MESURE DE PROFIL MAGNÉTIQUE DE CHAMP MAGNÉTIQUE CC ET PROCÉDÉ DE MESURE DE PROFIL MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2011 JP 2011210008**

(43) Date of publication of application:
**06.08.2014 Bulletin 2014/32**

(73) Proprietor: **Akita University**
**Akita-shi**
**Akita 010-8502 (JP)**

(72) Inventors:
• **SAITO Hitoshi**
**Akita-shi**
**Akita 010-8502 (JP)**
• **YOSHIMURA Satoru**
**Akita-shi**
**Akita 010-8502 (JP)**

(74) Representative: **Müller-Boré & Partner**
**Patentanwälte PartG mbB**
**Friedenheimer Brücke 21**
**80639 München (DE)**

(56) References cited:
**EP-A2- 1 830 172      WO-A1-2009/101991**
**JP-A- 2007 232 596      JP-B1- 4 769 918**
**JP-B1- 4 769 918      US-A1- 2011 030 109**

• **SAITO HITOSHI ET AL: "Direction detectable static magnetic field imaging by frequency-modulated magnetic force microscopy with an AC magnetic field driven soft magnetic tip", JOURNAL OF APPLIED PHYSICS, AMERICAN INSTITUTE OF PHYSICS, US, vol. 109, no. 7, 6 April 2011 (2011-04-06) , pages 7E330-7E330, XP012148686, ISSN: 0021-8979, DOI: 10.1063/1.3564944**

**Description**

Technical Field

The present invention relates to a technique to measure a magnetic profile of a surface of a specimen generating a direct-current (DC) magnetic field by scanning an area on the surface of the specimen by means of a probe on a tip of a driven cantilever.

Specifically, the present invention relates to a magnetic profile measuring technique using, as an initial data, amplitude and a phase of the magnetic field obtained by scanning the scanning area, or $\alpha$-component and $\beta$-component on Gauss plane, thereby making it possible to obtain an image of magnetic field distribution (a perpendicular magnetic field image and/or an in-plane magnetic field image) on the surface of the specimen generating a direct-current (DC) magnetic field.

Background Art

Conventionally, a magnetic force microscope (MFM) is known as a device to obtain a magnetic profile of a specimen.

MFM includes ones to observe alternating-current magnetic field (AC magnetic field) and ones to observe direct-current magnetic field (DC magnetic field).

Since the present invention is a technique related to the MFM to observe DC magnetic field, hereinafter a conventional technique of the MFM to observe DC magnetic field is described.

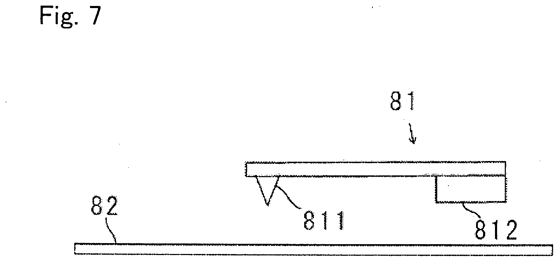

Fig. 7 is a figure to explanain a conventional MFM to observe DC magnetic field in which a probe 811 of a cantilever 81 is made of a hard magnetic material (see Patent Document 1).

The hard magnetic material is a material which hardly cause magnetization reversal once the material is magnetized. In the MFM of Fig. 7, an alloy of cobalt and chrome, an alloy of iron and platinum or the like is employed for the probe 811.

In the MFM of Fig. 7, the cantilever 81 is driven by a piezoelectric element 812 at a resonant frequency of the cantilever or at a frequency close to the resonant frequency of the cantilever (for example, around 300 kHz).

When two-dimensional scanning is carried out on a surface of a specimen 82 by means of the probe 811 of the cantilever, a magnetic interaction occurs between the probe 811 and the specimen 82.

This magnetic interaction makes the cantilever 81 act as if its spring constant had changed while vibrating. This apparent change in the spring constant changes the resonant frequency of the cantilever 81. As the resonant frequency of the cantilever changes, amplitude and a phase of the cantilever also change.

In the MFM of Fig. 7, vibration whose amplitude and phase have been changed is measured by for example optical detection. This makes it possible to obtain a magnetic profile (for example, magnetic characteristics corresponding to recording state) of the specimen 82 as an image of magnetic field distribution.

Patent Document 3 discloses a magnetic field observation device for observing a leakage magnetic field from a magnetic body sample comprising: a probe, the magnetization of which is reversed more easily than that of the magnetic body sample; an excitation mechanism for exciting the probe; a scanning mechanism for causing the probe to scan over the magnetic body sample by moving the probe and the magnetic body sample relatively to each other; an AC magnetic field generation mechanism for applying to the probe an AC magnetic field with certain magnitude with which the magnetization of the probe can be periodically reversed and the magnetization of the magnetic body sample cannot be reversed; and a modulation measurement mechanism that can measure the extent of periodical frequency modulation of the probe's oscillation, resulting from an apparent spring constant of the probe periodically changed by a force which is applied to the probe by alternating force due to magnetic interaction between the magnetization of the probe and the magnetization of the magnetic body sample and the strength of which is periodically changed, by means of frequency demodulation or by measuring the strength of one sideband wave spectrum among sideband wave spectrums generated by the frequency modulation.

Patent Document 4 discloses a magnetic resonance force microscope comprising an RF magnetic field generator for producing an RF magnetic field uniformly over the whole of a sample. A cantilever self-excitation loop portion self-excites the cantilever. Spins in the sample are thus controlled to produce a magnetic resonance force. A frequency demodulator measures the resonant frequency of the cantilever from the output detection signal from a cantilever displacement-measuring instrument based on the magnetic resonance force. The shift of the resonant frequency of the cantilever is measured. A scanner is controlled to keep constant the DC component of the amount of shift in the cantilever resonant frequency. The distance from the sample surface to the probe tip is adjusted. A controlled signal of a scanner driver power supply creates an AFM image of the sample. A phase detector creates an MRFM image according to the AC component of the amount of shift in the cantilever resonant frequency in the frequency demodulator.

Non-Patent Document 1 discloses direction detectable static magnetic field imaging, which directly distinguishes the up and down direction of static perpendicular magnetic field from a sample surface and the polarity of magnetic charges on the surface, based on a frequency-modulated magnetic force microscopy (FM-MFM), which uses a frequency modulation of the cantilever oscillation induced by an alternating force from the tip-sample magnetic interaction. This method enables measurement of the static magnetic field near a sample surface, which is masked by short range forces of the surface.

Citation List

Patent Literature

Patent Document 1: Japanese Patent Application Laid-Open No. 2003-65935
Patent Document 2: WO 2009/101991 and family member US2011/0030109 A1
Patent Document 3: JP 4 769 918 B1 and family member EP 2 613 160 A1
Patent Document 4: EP 1 830 172 A2

Non-Patent Literature

Non-Patent Document 1: "Direction detectable static magnetic field imaging by frequency-modulated magnetic force microscopy with an AC magnetic field driven soft magnetic tip" by Saito Hitoshi et al., Journal of Applied Physics, US, vol. 109, no. 7, 6 April 2011.

Disclosure of the Invention

Problems to be Solved by the Invention

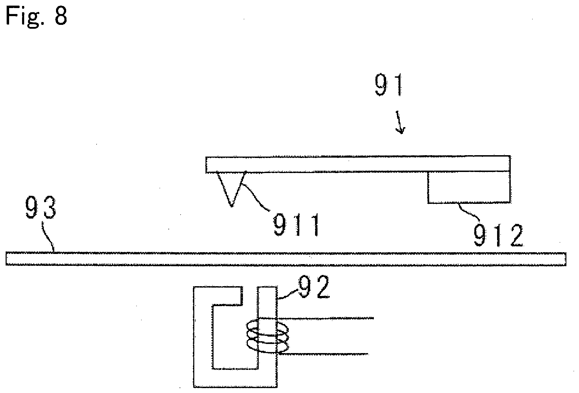

Unfortunately, the MFM of Fig. 7 has drawbacks that its signal intensity is weak and it has a bad S/N ratio.
On the other hand, an MFM to observe DC magnetic field shown in Fig. 8 which employs a probe of soft magnetism as a prove 911 of a cantilever 91 has been applied for a patent by the present inventors (see Patent Document 2).
The MFM of Fig. 8 can mend the above drawbacks. In the MFM of Fig. 8, a material which causes a magnetization reversal under a comparatively weak outer magnetic field, such as nickel-iron Ni-Fe, is employed as the probe 911.
In the MFM of Fig. 8, an alternating-current magnetic field generator 92 is provided on the side of a specimen 93 opposite from the cantilever 91. This alternating-current magnetic field generator 92 does not affect magnetization state of a surface of the specimen 93, but it can change the direction of magnetization (magnetic moment) of the probe 911.
In the MFM of Fig. 8 as well, the cantilever 91 is driven by means of a piezoelectric element 912 at a resonant frequency of the cantilever or at a frequency close to the resonant frequency of the cantilever (for example, around 300 kHz).
Frequency of alternating-current magnetic field generated by the alternating-current magnetic field generator 92 can be 10 Hz to 1 kHz which makes magnetization reversal of the probe 911 easily occur.
When the alternating-current magnetic field generator 92 is operated while the cantilever 91 is driven, magnetic polarity of the probe 911 on a tip of the cantilever 91 is changed. This change generates a non-resonant alternating magnetic force having a frequency different from the resonant frequency of the cantilever 91 between the probe 911 and the specimen 93.
When two-dimensional scanning is carried out on the surface of the specimen 93 by means of the probe 911, a non-resonant alternating magnetic interaction occurs between the probe 911 and the specimen 93.
This non-resonant alternating magnetic force cannot drive the cantilever 91 by itself. When the cantilever 91 is driven at a frequency around the resonant frequency of the cantilever by means of a piezoelectric element or the like while the non-resonant alternating magnetic force works, though, this non-resonant alternating magnetic force makes the cantilever 91 act as if its spring constant had changed. Because of this apparent change in the spring constant, a frequency modulation occurs in vibration of the cantilever 91.
On the other hand, when the cantilever 91 is driven at a frequency different from the resonant frequency of the cantilever 91 by means of a piezoelectric element or the like, an amplitude modulation as well as the frequency modulation in the vibration of the cantilever 91.
In the MFM of Fig. 8, the vibration modulated by frequency and amplitude is for example optically detected and demodulated by frequency (or by amplitude), then the amplitude and the phase of the vibration are measured, whereby it is made possible to obtain a magnetic profile (for example, magnetic characteristics corresponding to a recording state) of the specimen 93 as an image of magnetic field distribution.

In the MFM of Fig. 8, by detecting signals demodulated by frequency (or by amplitude) by means of a lock-in amplifier or the like with low noise, it is possible to measure the magnetic profile of the surface of the specimen 93 (for example, a magnetic recording medium such as a magnetic disk).

In the MFM of Fig. 8, in advance of the measurement of the magnetic profile of the surface of the specimen 93 described above, roughness of the surface can be detected by two-dimensional scanning by means of the probe contacting on the surface of the specimen 93. When measuring the magnetic profile, it is possible to keep a constant distance between the surface of the specimen 93 and the probe 911, utilizing the obtained information of roughness of the surface.

In measurement of the magnetic profile of the surface of the specimen 93, an alternating-current magnetic field is applied to the probe 911, whereby a non-resonant magnetic force having a frequency different from the resonant frequency of the cantilever 91 is caused between the cantilever 91 and the specimen 93.

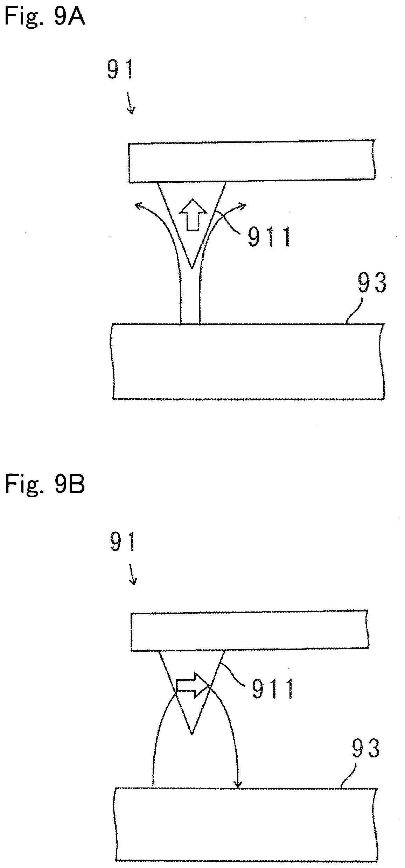

Then assuming, as shown in Fig. 9A, that a perpendicular magnetization component of the probe (a component of magnetization of the probe in a direction perpendicular to a specimen surface (white arrow)) is synchronized with a phase of magnetic field in the direction perpendicular to the surface of the specimen 93, it can be decided, at a point of time when the magnetization of the probe 911 is perpendicular to the specimen surface, that perpendicular magnetic field component is maximum (i.e. in-plane magnetic field component is zero) when the amplitude of the demodulated signal is maximum, and that the perpendicular magnetic field component is zero (i.e. the in-plane magnetic field component is maximum) when the amplitude of the demodulated signal is zero.

Also assuming, as shown in Fig. 9B, that an in-plane magnetization component of the probe (a component of magnetization of the probe in a direction parallel to the specimen surface (white arrow)) is synchronized with a phase of magnetic field in a direction parallel to the surface of the specimen 93, it can be decided, at a point of time when the magnetization of the probe 911 is parallel to the surface of the specimen 93, that the in-plane magnetic field component is maximum (i.e. the perpendicular magnetic field component is zero) when the amplitude of the demodulated signal is maximum, and that the in-plane magnetic field component is zero (i.e. the perpendicular magnetic field component is maximum) when the amplitude of the demodulated signal is zero.

The magnetic profile of the specimen by the MFM shown in Fig. 8 is measured by means of a lock-in amplifier with a signal source (current source) of the alternating-current magnetic field generator 92 as a reference signal.

In Fig. 9A, the perpendicular magnetization component (the component of magnetization of the probe in a direction perpendicular to the surface of the specimen 93) is synchronized with the phase of alternating-current magnetic field generated by the alternating-current magnetic field generator that generates the magnetic field perpendicular to the surface of the specimen 93. In this case, at a point of time when the magnetization of the probe 911 is perpendicular to the surface of the specimen 93, the perpendicular magnetic field component is maximum (i.e. the in-plane magnetic field component is zero) when the amplitude of the demodulated signal is maximum, and the perpendicular magnetic field component is zero (i.e. the in-plane magnetic field component is maximum) when the amplitude of the demodulated signal is zero.

Also, in Fig. 9B, the in-plane magnetization component of the probe 911 (a component of magnetization of the probe 911 in a direction parallel to the specimen surface) is synchronized with the phase of the alternating-current magnetic field generated by the alternating-current magnetic field generator that generates a magnetic field in a direction parallel to the surface of the specimen 93. In this case, when the magnetization of the probe 93 is parallel to the surface of the specimen 93, the in-plane magnetic field component is maximum (i.e. the perpendicular magnetic field component is zero) when the amplitude of the demodulated signal is maximum, and the in-plane magnetic field component is zero (i.e. the perpendicular magnetic field component is maximum) when the amplitude of the demodulated signal is zero.

However, in measuring the magnetic profile, the phase of the measurement signal may delay inside of the electric circuit of the alternating-current magnetic field generator on the side of the power source or inside of the electric circuit of the demodulator.

Further, change of the magnetization of the probe 911 may delay more than the delay in the change of the magnetic field of the alternating-current magnetic field generator, resulting in a further delay in the phase.

Since the delay in the phase shifts the timing of the time-dependent change of magnetization of the probe 911, when the phase delay occurs, the magnetization of the probe 911 does not become perpendicular to the surface of the specimen 93 in the synchronizing signal output of the lock-in amplifier, which makes it impossible to measure the perpendicular magnetic field component alone.

Also, where a phase delay occurs in the orthogonal signal output of the lock-in amplifier, the magnetization of the probe 911 does not become parallel to the surface of the specimen 93, which makes it impossible to measure the in-plane magnetic field component alone.

The object of the present invention is to provide a magnetic profile measuring technique which makes it possible to obtain a perpendicular magnetic field image, in-plane magnetic field image, or an synthesized magnetic field image of the perpendicular magnetic field and the in-plane magnetic field, depending on phase change, using image data of magnetic field distribution obtained for the specimen that generates a direct-current (DC) magnetic field,.

Another object of the present invention is to provide a magnetic profile measuring technique which makes it possible to obtain an in-plane magnetic field image that does not include a perpendicular magnetic field component and a perpendicular magnetic field image that does not include an in-plane magnetic field component, using image data of magnetic field distribution obtained for the specimen that generates a direct-current (DC) magnetic field.

Means for Solving the Problems

The present inventors made the present invention based on the finding that even from an image of perpendicular magnetic field distribution having an indefinite phase, the image being obtained from a perpendicular magnetic field component perpendicular to a surface of the specimen and an in-plane magnetic field component parallel to the surface of the specimen, it is possible to obtain, by adjusting the phase, an image of magnetic field distribution having a desired phase unaffected by phase delay of measurement signal inside of signal processing circuit or phase delay of magnetic field generated by an alternating-current magnetic field generator.

A magnetic profile measuring device of the present invention has following embodiments.

(1) A magnetic profile measuring device according to claim 1 which scans a scanning area on a surface of a specimen by means of a magnetized probe on a tip of a driven cantilever, detects vibration of the cantilever, and generates an image of magnetic field distribution of the scanning area based on results of the detection, the device including:

the cantilever wherein the probe is equipped on the tip of the cantilever;
a driver driving the cantilever at a resonant frequency of the cantilever or at a frequency close to the resonant frequency of the cantilever;
an alternating-current magnetic field generator generating an alternating-current magnetic field and periodically reversing the magnetic polarity of the probe, and thereby modulating driven vibration of the cantilever by frequency or by both frequency and amplitude;
a vibration sensor detecting vibration of the probe;
a demodulator demodulating from a detection signal of the vibration sensor a magnetic signal which corresponds to an alternating magnetic force occurring between the probe and the specimen, and detecting the demodulated magnetic signal as (A) two separate signal components having phase difference of 90° and being orthogonal to each other or (B) amplitude and a phase of the magnetic field at the position of the probe;
a scanning mechanism scanning the scanning area by means of the probe;
a data storage storing an initial data for each coordinate of the scanning area wherein the initial data is (A) the two separate signal components orthogonal to each other or (B) the amplitude and phase of the magnetic field, and wherein the initial data is obtained by scanning the scanning area by means of the scanning mechanism on condition that the demodulation is synchronized with operation of the alternating-current magnetic field generator;
a modified data generator recalling the initial data from the data storage and generating a plurality of data by modifying the phase of the initial data; and
an image display device displaying an image of magnetic field distribution based on data generated for each coordinate of the scanning area by the modified data generator.

(2) The magnetic profile measuring device according to (1), wherein
where the magnetic field at the position of the probe is represented by

$$H_\alpha + jH_\beta \equiv H_0 \exp(j\varphi)$$

in $\alpha$-$\beta$ complex plane which is Gauss plane;
amplitude of the magnetic field at the position of the probe, $H_0$, is represented by

$$H_0 \equiv (H_\alpha^2 + H_\beta^2)^{1/2}$$

which is a distance from the origin in the $\alpha$-$\beta$ complex plane;
the phase of the magnetic field at the position of the probe, $\varphi$, is represented by

$$\varphi \equiv \tan^{-1}(H_\beta/H_\alpha)$$

which is an argument $\varphi$ in the $\alpha$-$\beta$ complex plane;
$\alpha$-component of the magnetic field at the position of the probe is represented by

$$H_\alpha = H_0 \cos\varphi$$

which is a component parallel to the $\alpha$-axis; and
$\beta$-component of the magnetic field at the position of the probe is represented by

$$H_\beta = H_0 \cos\varphi$$

which is a component parallel to the $\beta$-axis perpendicular to the $\alpha$-axis,
the demodulator detects the demodulated magnetic signal as (A) a data pair of the $\alpha$-component and the $\beta$-component $(H_\alpha, H_\beta)$ or (B) a data pair of the amplitude and the phase $(H_0, \varphi)$.

(3) The magnetic profile measuring device according to (2), wherein
either (X) the $\alpha$-component is a perpendicular magnetic field component of the magnetic field wherein the perpendicular magnetic field component is a component perpendicular to the surface of the specimen; and the $\beta$-component is an in-plane magnetic field component of the magnetic field wherein the in-plane magnetic field component is a component parallel to the surface of the specimen,
or (Y) the $\alpha$-component is an in-plane magnetic field component of the magnetic field wherein the in-plane magnetic field component is a component parallel to the surface of the specimen; and the $\beta$-component is a perpendicular magnetic field component of the magnetic field wherein the perpendicular magnetic field component is a component perpendicular to the surface of the specimen.

(4) The magnetic profile measuring device according to (2) or (3),
wherein the magnetic field at the position of the probe is displayed by means of the image display device by making the $\alpha$-component and/or the $\beta$-component into an image depending on variation of the argument $\varphi$.

(5) A method for measuring magnetic profile according to claim 5 including scanning a scanning area on a surface of a specimen by means of a magnetized probe on a tip of a driven cantilever, detecting vibration of the cantilever, and generating an image of magnetic field distribution of the scanning area based on results of the detection, the method including the steps of:

   driving the cantilever at a resonant frequency of the cantilever or at a frequency close to the resonant frequency of the cantilever, wherein the probe is equipped on the tip of the cantilever (S110);
   generating an alternating-current magnetic field and periodically reversing the magnetic polarity of the probe, and thereby modulating driven vibration of the cantilever by frequency (S120);
   detecting vibration of the probe and demodulating from the detection signal a magnetic signal which corresponds to an alternating magnetic force occurring between the probe and the specimen (S130);
   detecting the demodulated magnetic signal as (A) two separate signal components which have phase difference of 90° and are orthogonal to each other or (B) amplitude and a phase of the magnetic field at the position of the probe (S140);
   scanning the scanning area by means of the probe (S150);
   storing an initial data in a data storage for each coordinate of the scanning area wherein the initial data is (A) the two separate signal components orthogonal to each other or (B) the amplitude and phase of the magnetic field, and wherein the initial data is obtained by scanning the scanning area on condition that the demodulation is synchronized with the generation of the alternating-current magnetic field (S160);
   recalling the initial data from the data storage and generating a plurality of data by modifying the phase of the initial data (S170) ;
   displaying an image of a magnetic field distribution based on data generated by modifying the phase of the initial data, on an image display device (S180); and
   measuring the magnetic profile of the specimen based on each image of magnetic field distribution displayed on the image display device (S190).

(6) The method for measuring magnetic profile according to (5), wherein in the step of detecting the demodulated magnetic signal (S140),
where the magnetic field at the position of the probe is represented by

$$H_\alpha + jH_\beta \equiv H_0 \exp(j\varphi)$$

in $\alpha$-$\beta$ complex plane which is Gauss plane;
amplitude of the magnetic field at the position of the probe, $H_0$, is represented by

$$H_0 \equiv (H_\alpha{}^2 + H_\beta{}^2)^{1/2}$$

which is a distance from the origin in the $\alpha$-$\beta$ complex plane;
the phase of the magnetic field at the position of the probe, ($\varphi$, is represented by

$$\varphi \equiv \tan^{-1}(H_\beta/H_\alpha)$$

which is an argument $\varphi$ in the $\alpha$-$\beta$ complex plane;
$\alpha$-component of the magnetic field at the position of the probe is represented by

$$H_\alpha = H_0 \cos\varphi$$

which is a component parallel to the $\alpha$-axis; and
$\beta$-component of the magnetic field at the position of the probe is represented by

$$H_\beta = H_0 \cos\varphi$$

which is a component parallel to the $\beta$-axis perpendicular to the $\alpha$-axis,
the demodulated magnetic signal is detected as (A) a data pair of the $\alpha$-component and the $\beta$-component ($H_\alpha$, Hp) or (B) a data pair of the amplitude and the phase ($H_0$, $\varphi$).
(7) The method for measuring magnetic profile according to (6), wherein
either (X) the $\alpha$-component is a perpendicular magnetic field component of the magnetic field wherein the perpendicular magnetic field component is a component perpendicular to the surface of the specimen; and the $\beta$-component is an in-plane magnetic field component of the magnetic field wherein the in-plane magnetic field component is a component parallel to the surface of the specimen,
or (Y) the $\alpha$-component is an in-plane magnetic field component of the magnetic field wherein the in-plane magnetic field component is a component parallel to the surface of the specimen; and the $\beta$-component is a perpendicular magnetic field component of the magnetic field wherein the perpendicular magnetic field component is a component perpendicular to the surface of the specimen.
(8) (7), The method for measuring magnetic profile according to (6) or
wherein the magnetic field at the position of the probe is displayed by means of the image display device by making the $\alpha$-component and/or the $\beta$-component into an image depending on variation of the argument $\varphi$.

Effects of the Invention

The present invention makes it possible to obtain an image of perpendicular magnetic field of specimen that does not include an in-plane magnetic field component and to obtain an image of in-plane magnetic field of specimen that does not include a perpendicular magnetic field component, using an obtained image data of magnetic field distribution.

In other words, in measuring magnetic profile of a specimen by MFM, perpendicular magnetic field component and in-plane magnetic field component may overlap, but the present invention makes it possible to mend or resolve this overlap of magnetic field components.

This makes it possible to separate a magnetic field component observed at a measurement point into a perpendicular magnetic field component and an in-plane magnetic field component.

Brief Description of the Drawings

Fig. 1 is a figure to explain an embodiment of a magnetic profile measuring device of the present invention;

Fig. 2 is a flowchart showing an embodiment of a method for measuring magnetic profile of the present invention;

Fig. 3 is a figure illustrating an embodiment of the magnetic profile measuring device of the present invention and processes of an embodiment of the method for measuring magnetic profile of the present invention, as well as a figure for supplementary explanation illustrating a phase before modified data generating process is carried out by a modified data generator;

Fig. 4 is a figure illustrating an embodiment of the magnetic profile measuring device of the present invention and processes of an embodiment of the method for measuring magnetic profile of the present invention, as well as a figure for supplementary explanation illustrating a phase before modified data generating process is carried out by a modified data generator;

Fig. 5A is an image of perpendicular magnetic field distribution having an indefinite phase stored in a data storage, and Fig. 5B is an example image of in-plane magnetic field distribution having an indefinite phase stored in the data storage;

Fig. 6 provides synthesized images of perpendicular magnetic field distribution images and in-plane magnetic field distribution images made from images of Figs. 5A and 5B (data stored in the data storage 17), which synthesized images show examples of magnetic field distribution images each having an adjusted phase;

Fig. 7 is a figure to explain a conventional MFM to observe DC magnetic field in which a probe of a cantilever is a probe with hard magnetic properties;

Fig. 8 is a figure to explain a conventional MFM to observe DC magnetic field in which a probe of a cantilever is a probe with soft magnetic properties;

Fig. 9 includes figures to explain operation of the MFM of Fig. 8; Fig. 9A is a figure illustrating a case where a perpendicular magnetization component of the probe (a component of magnetization of the probe in a direction perpendicular to the specimen surface) is synchronized with a phase of magnetic field in a perpendicular direction of the specimen surface, and Fig. 9B is a figure illustrating a case where an in-plane magnetization component of the probe (a component of magnetization of the probe in a direction parallel to the specimen surface) is synchronized with a phase of magnetic field in a parallel direction to the specimen surface.

Modes for Carrying Out the Invention

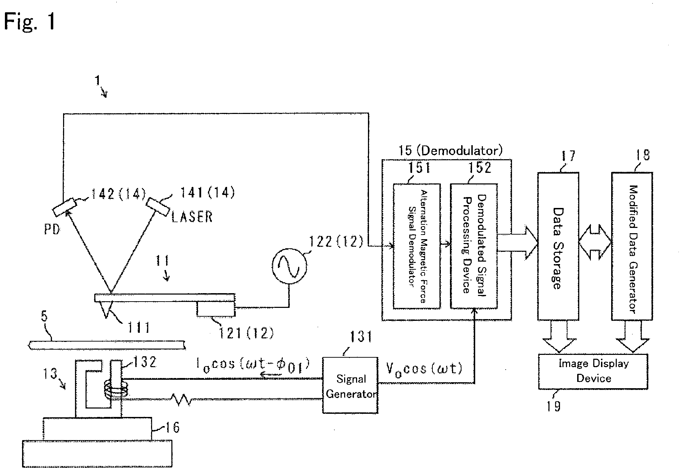

Fig. 1 is a figure to explain an embodiment of the magnetic profile measuring device of the present invention.

In Fig. 1, a magnetic profile measuring device 1 includes a cantilever 11, a driver 12, an alternating-current magnetic field generator 13, a vibration sensor 14, a demodulator 15, a scanning mechanism 16, a data storage 17, a modified data generator 18, and an image display device 19. The magnetic profile measuring device 1 can scan a scanning area on a surface of a specimen 5 by means of a magnetized probe 111 on a tip of the driven cantilever 11, detect vibration of the cantilever 11, and generate an image of magnetic field distribution of the scanning area based on results of the detection with following configuration.

The cantilever 11 has the probe 111 on its tip. The probe 111 is formed in a cone shape in this embodiment, and a film made of a so-called soft magnetic material is formed on a surface of the probe 111. The film made of the soft magnetic material is magnetized via the specimen 5 by a magnetic field from the alternating-current magnetic field generator 13, but magnetization state of the specimen 5 is not affected by the magnetic field.

The driver 12 is composed of a piezoelectric element 121 and a power source 122. The power source 122 drives the piezoelectric element 121, which drives the cantilever 11. The driver 12 drives the cantilever 11 at a resonant frequency of the cantilever 11 or at a frequency close to the resonant frequency of the cantilever 11 (in the present invention, the resonant frequency of the cantilever and a frequency close to the resonant frequency of the cantilever are referred to as "carrier frequency"). In this embodiment, the carrier frequency can be for example 300 kHz.

The alternating-current magnetic field generator 13 is, in this embodiment, a small electromagnet including a coil and provided on the opposite side of the specimen 5 from the cantilever 11. That is, the alternating-current magnetic field generated by the alternating-current magnetic field generator 13 works on the probe 111 through the specimen 5, and the direction of magnetization (magnetic moment) of the probe 111 changes periodically. Because of this, driven vibration of the cantilever 11 is modulated by frequency by an alternating-current magnetic force which occurs between the probe 11 and the specimen 5. Frequency of the magnetic field generated by the alternating-current magnetic field generator 13 can be around 10 Hz to 1 kHz for example. As described above, the magnetic field generated by the alternating-current magnetic field generator 13 has intensity such that the magnetization state of the specimen is not affected.

The vibration sensor 14 includes a laser 141 and a photodiode (PD) 142, and detects vibration of the probe 111 on the tip of the cantilever 11.

The demodulator 15 includes an alternating magnetic force signal demodulator 151 and a demodulated signal processing device 152. The alternating magnetic force signal demodulator 151 demodulates (by frequency or by amplitude) from a detection signal of the vibration sensor 14 the modulated probe vibration caused by the alternating magnetic force occurring between the probe 111 and the specimen 5.

The demodulated signal processing device 152 is, in specific, a lock-in amplifier, and detects from the demodulated alternating magnetic force an in-phase component $H_\alpha$ and an orthogonal component $H_\beta$ wherein the component $H_\alpha$ is synchronized with a reference signal of the lock-in amplifier for a magnetic field at the position of the probe, and the component $H_\beta$ has a phase difference of 90° from the reference signal, or has amplitude $H_0$ and a phase $\varphi$ of the magnetic field.

Detecting the in-phase component $H_\alpha$ and the orthogonal component $H_\beta$ of the lock-in amplifier for the magnetic field of each coordinate of the scanning area is equivalent to detecting the amplitude $H_0$ and the phase $\varphi$ of the magnetic field.

The demodulated magnetic signal can be separated into a perpendicular magnetic field component perpendicular to a surface of the specimen 5 and an in-plane magnetic field component parallel to the surface of the specimen 5, by a modulated data generating process described later.

The scanning mechanism 16, moving on the specimen 5, scans the scanning area on the surface of the specimen 5 by means of the probe 111. The scanning mechanism 16 also can be configured to move the cantilever 11. Scanning speed of the scanning mechanism 16 is slow enough to be ignored when the demodulator 15 demodulates the alternating magnetic force.

The data storage 17 stores, as an initial data, the in-phase component $H_\alpha$ and the orthogonal component $H_\beta$ of the lock-in amplifier for the magnetic field of each coordinate of the scanning area, or the amplitude $H_0$ and the phase $\varphi$ of the magnetic field of the lock-in amplifier, wherein each component is obtained by scanning the scanning area by means of the scanning mechanism 16. Storing the in-phase component $H_\alpha$ and the orthogonal component $H_\beta$ of the lock-in amplifier for the magnetic field of each coordinate of the scanning area as the initial data is equivalent to storing the amplitude $H_0$ and the phase $\varphi$ of the magnetic field as the initial data.

The modulated data generator 18 recalls the initial data of the in-phase component $H_\alpha$ and the orthogonal component $H_\beta$ of, the lock-in amplifier for the magnetic field of each coordinate of the scanning area from the data storage 17 (or each data of the amplitude $H_0$ and the phase $\varphi$ of the magnetic field).

The modulated data generator 18 generates, for each coordinate of the scanning area and for the in-phase component $H_\alpha$ and the orthogonal component $H_\beta$ of the lock-in amplifier for the magnetic field, a plurality of data pairs of a component parallel to $\alpha$-axis of $\alpha$-$\beta$ complex plane ($\alpha$-component) and a component parallel to $\beta$-axis perpendicular to the $\alpha$-axis ($\beta$-component) in the $\alpha$-$\beta$ complex plane, wherein the amplitude $H_0$ is fixed and the phase $\varphi$ is modulated (increased or decreased).

The image display device 19 displays an image of magnetic field distribution based on the initial data for each coordinate of the scanning area stored in the data storage 17 and an image of magnetic field distribution based on data for each coordinate of the scanning area generated by the modulated data generator 18.

In advance of the measurement of the magnetic profile of the specimen 5, roughness of the surface of the specimen 5 can be measured and stored. Thereafter the magnetic profile of the specimen 5 can be measured while a constant distance is kept between the probe 111 and the surface of the specimen 5. Measurement of the roughness of the surface of the specimen 5 may be carried out by contacting the probe 111 of the cantilever 11 to the surface of the specimen 5.

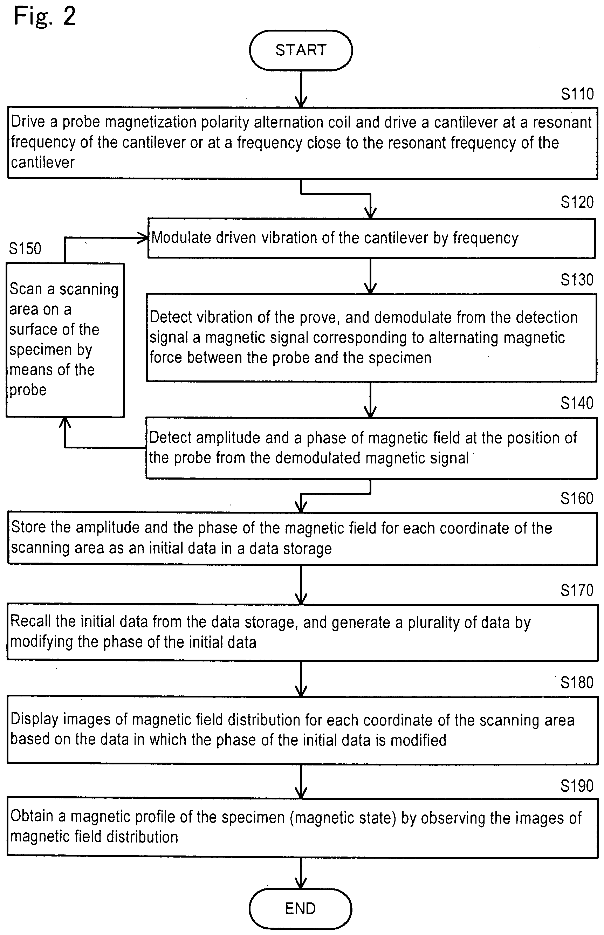

Fig. 2 is a flowchart showing an embodiment of the method for measuring the magnetic profile of the present invention.

Since the method for measuring the magnetic profile of Fig. 2 is carried out by means of the magnetic profile measuring device 1 of Fig. 1, operation of the magnetic profile measuring device 1 of Fig. 1 will be mainly explained referring to the flowchart of Fig. 2 in the following.

In Fig. 1, the power source 122 of the driver 12 drives the piezoelectric element 121 and drives the cantilever 11 at the resonant frequency of the cantilever 11 or at a frequency close to the resonant frequency of the cantilever 11 (carrier frequency) (S110). Comparing with "signal" and "carrier" of frequency modulation in communication systems, the alternating-current magnetic field corresponds to the "signal" (frequency of the signal is, in this embodiment, around 10 Hz to 1 kHz) and mechanical driving of the cantilever 11 by the piezoelectric element 121 corresponds to the "carrier" (frequency of the carrier is for example 300 kHz).

In Fig. 1, the alternating-current magnetic field generator 13 includes a signal generator 131 and a coil main body 132 (a small electromagnet including a coil) as described above. The signal generator 131 drives the coil main body 132 by an alternating-current voltage V represented by Formula (1):

$$V = V_0 \cos(\omega t) \quad \ldots (1)$$

$V_0$ in Formula (1) is the amplitude of the alternating-current voltage, and its initial phase is zero. The alternating-current voltage V applies current I represented by Formula (2) to the winding of the coil main body 132:

$$I = I_0 \cos(\omega t - \varphi_{01}) \quad \ldots (2)$$

$I_0$ in Formula (2) is the amplitude of alternating current.

Also, a delay angle $\varphi_{01}$ derives from resistance, inductance etc. of a circuit composing the alternating-current magnetic field generator 13.

By the current $I_0$ of Formula (2), the alternating-current magnetic field generator 13 generates a magnetic field in a direction perpendicular to the surface of the specimen 5 (perpendicular magnetic field component $H_V$):

$$H_V = H_0 \cos(\omega t - \varphi_{02}) \quad \ldots (3)$$

$H_0$ in Formula (3) is the amplitude of the alternating-current magnetic field. The magnetic field in perpendicular direction (the perpendicular magnetic field component $H_V$) becomes maximum, a delay time of $\varphi_{02}/\omega$ after the alternating-current voltage V (see Formula (1)) of the signal generator 131. Herein, a delay angle $\varphi_{02}$ is an angle which is a sum of a delay angle ($\varphi_{dA}$) in the alternating-current magnetic field generator 13 and the delay angle $\varphi_{01}$ in Formula (2).

The delay angle $\varphi_{dA}$ is an angle caused by a delay in magnetization response that occurs when the alternating-current magnetic field is applied to a magnetic core material of the coil of the alternating-current magnetic field generator 13 etc.

As described above, the magnetic field from the alternating-current magnetic field generator 13 magnetizes the probe 111 having a soft magnetic material, without changing the magnetization state of the specimen 5, resulting in the magnetic moment of the probe 111 having a magnetization component rotating and repeatedly reversing by the alternating-current magnetic field from the alternating-current magnetic field generator 13.

Thus the alternating magnetic force occuring between the probe 111 and the specimen 5 can modulate driven vibration of the cantilever 11 by frequency (S120).

The vibration sensor 14 irradiates a laser beam from a laser 141 to an upper surface of the tip of the cantilever 11 to detect its reflected light by a photodiode 142, thereby detecting the vibration of the probe 111. The alternating magnetic force signal demodulator 151 demodulates from detection signal of the vibration sensor 14 the alternating magnetic force in a direction perpendicular to the surface of the specimen 5 (alternating magnetic force signal) caused by the alternating-current magnetic field at the position of the probe (S130) .

Output F of the alternating magnetic force signal demodulator 151 is represented by Formula (4):

$$F = F_0 \cos(\omega t - \varphi_{03}) \quad \ldots (4)$$

$F_0$ in Formula (4) is the amplitude of the alternating magnetic force, and a delay angle $\varphi_{03}$ is an angle which is a sum of a delay caused when a delay in magnetization response of the soft magnetic material composing the probe 111 to applyied magnetic field etc., a delay caused when a delay in detection circuit of the vibration sensor 14 etc. occurs (these delays are defined as $\varphi_{dB}$) , and the delay angle $\varphi_{02}$ in Formula (3). Herein, when the frequency of the magnetic field generated by the alternating-current magnetic field generator 13 is low, $\varphi_{03}$ becomes almost equal to $\varphi_{02}$.

The demodulated signal processing device 152 (lock-in amplifier) detects amplitude ($F_0$) and a phase ($-\varphi_{03}$) of the alternating magnetic force signal F demodulated by the alternating magnetic force signal demodulator 151 (S140).

The demodulated alternating magnetic force signal F is represented by Formula (5):

$$\begin{aligned}
F_0 &\cos(\omega t - \varphi_{03}) \\
&= F_0 \cos(-\varphi_{03}) \cos(\omega t) - F_0 \sin(-\varphi_{03}) \sin(\omega t) \\
&= F_0 \cos(-\varphi_{03}) \cos(\omega t) + F_0 \sin(-\varphi_{03}) \cos(\omega t + \pi/2) \quad \ldots (5)
\end{aligned}$$

The demodulated signal processing device 152 separates the demodulated alternating magnetic force signal F into

$$F_0 \cos(-\varphi_{03}) \cos(\omega t) \quad \ldots (6A)$$

and

$$F_0 \sin(-\varphi_{03}) \cos(\omega t + \pi/2) \quad \ldots (6B).$$

Formula (6A), $F_0 \cos(-(\varphi_{03})\cos(\omega t)$ corresponds to the component of the magnetic field perpendicular to the surface of the specimen 5 (perpendicular magnetic field component) which becomes maximum with a delay of the phase angle $\varphi_{03}$ in magnetization of the probe 111 from the voltage (having an initial phase of zero) of the alternating-current magnetic field generator 13.

Also, Formula (6B), $F_0 \sin(-\varphi_{03}) \cos(\omega t + \pi/2)$ corresponds to the component of the magnetic field parallel to the surface of the specimen 5 (in-plane magnetic field component) which becomes maximum with a delay of further 90° of phase angle in magnetization of the probe 111.

Herein, value of the above $\varphi_{03}$ can be obtained by, using a standard specimen whose magnetization state is known such as a perpendicular magnetic recording medium having a low recording density, and carrying out phase adjustment at a position where only a perpendicular magnetic field occurs or a position where only an in-plane perpendicular magnetic field occurs.

Herein, defining a direction perpendicular to the specimen surface as z-direction, a direction parallel to the specimen surface as x-direction, a component of magnetization m of the probe 111 in a direction perpendicular to the specimen surface as $m_z$, and a component of magnetization m of the probe 111 in a direction parallel to the specimen surface as $m_x$, the probe magnetization varies due to magnetic field H of Formula (3) generated by the alternating-current magnetic field generator, and can be represented by Formula (7), or Formulae (7A) and (7B):

$$m = m_0 \exp(j(\omega t - \varphi_{04})) = m_z + j m_x \quad \ldots (7)$$

$$m_z = m_0 \cos(\omega t - \varphi_{04}) \quad \ldots (7A)$$

$$m_x = m_0 \sin(\omega t - \varphi_{04}) \quad \ldots (7B)$$

The angle ($\varphi_{04}$ in Formulae (7A) and (7B) is a delay angle which is a sum of a delay in magnetization response of the soft magnetic material composing the probe 111 to applyed magnetic field etc. (defined as $\varphi_{dC}$) and the delay angle $\varphi_{02}$ in Formula (2). Herein, when the frequency of the magnetic field generated by the alternating-current magnetic field generator 13 is low, $\varphi_{04}$ becomes almost equal to $\varphi_{02}$.

An alternating magnetic force $F_z$ which is applied to the probe 111 from the specimen 5 and is perpendicular to the surface of the specimen 5 can be represented by Formula (8):

$$F_z = m_x(\partial H_z/\partial x) + m_z(\partial H_z/\partial z)$$

$$= m_x(\partial H_x/\partial z) + m_z(\partial H_z/\partial z)$$

$$= m_0 \sin(\omega t - \varphi_{04})(\partial H_x/\partial z) + m_0 \cos(\omega t - \varphi_{04})(\partial H_z/\partial z)$$

$$= m_0\{\sin(\omega t)\cos(-\varphi_{04}) + \cos(\omega t)\sin(-\varphi_{04})\}(\partial H_x/\partial z)$$

$$+ m_0\{\cos(\omega t)\cos(-\varphi_{04}) - \sin(\omega t)\sin(-\varphi_{04})\}(\partial H_z/\partial z) \quad \ldots (8)$$

Herein, since the magnetic field from the specimen 5 is an irrotational field generated by magnetic poles, a relationship represented by Formula (9) is satisfied:

$$(\partial H_z/\partial x) \; = \; (\partial H_x/\partial z) \quad \ldots (9)$$

By the alternating magnetic force $F_z$ which is applied to the probe 111 from the specimen 5 and is perpendicular to the surface of the specimen 5, spring constant of the probe vibration effectively changes by $(\partial F_z/\partial z)$, and frequency modulation occurs in proportion to the effective change of the spring constant.
That is, the demodulated signal corresponds to:

$$m_0\{\sin(\omega t)\cos(-\varphi_{04}) \; + \; \cos(\omega t)\sin(-\varphi_{04})\}(\partial^2 H_x/\partial z^2)$$

$$+ \; m_0\{\cos(\omega t)\cos(-\varphi_{04}) \; - \; \sin(\omega t)\sin(-\varphi_{04})\}(\partial^2 H_z/\partial z^2)$$

Also, a synchronizing signal measured by the demodulated signal processing device 152 (lock-in amplifier) corresponds to:

$$(\partial^2 H_z/\partial z^2)m_0\cos(-\varphi_{04}) \; + \; (\partial^2 H_x/\partial z^2)m_0\sin(-\varphi_{04})$$

and an orthogonal signal measured by the demodulated signal processing device 152 corresponds to:

$$(\partial^2 H_z/\partial z^2)m_0\cos(-\varphi_{04}) \; - \; (\partial^2 H_x/\partial z^2)m_0\sin(-\varphi_{04})$$

Therefore, the synchronizing signal measured by the demodulated signal processing device 152 corresponds to:

$$(\partial^2 H_z/\partial z^2)\cos(-\varphi_{04}) \; + \; (\partial^2 H_x/\partial z^2)\sin(-\varphi_{04})$$

which is a sum of a gradient of perpendicular magnetic field and a gradient of in-plane magnetic field, and the orthogonal signal corresponds to:

$$-(\partial^2 H_x/\partial z^2)\sin(-\varphi_{04}) \; + \; (\partial^2 H_z/\partial z^2)\cos(-\varphi_{04})$$

which is a sum of the gradient of in-plane magnetic field and the gradient of perpendicular magnetic field.
Herein, when the distance between the probe 111 and the specimen 5 is smaller than the magnetic moment length of the magnetization m, the component $m_z$ of the magnetization m of the probe 111 in a direction perpendicular to the surface of the specimen acts as a magnetic pole q formed on the tip of the probe, and the synchronizing signal measured by the demodulated signal processing device 152 (lock-in amplifier) corresponds to:

$$(\partial H_z/\partial z)q\cos(-\varphi_{04}) \; + \; (\partial^2 H_x/\partial z^2)m_0\sin(-\varphi_{04})$$

which is a sum of the gradient of perpendicular magnetic field and the gradient of in-plane magnetic field.
As will be described below, by adding ($\varphi_{04}$ as a phase adjustment value ($\varphi_C$ to the phase delay -$\varphi_{04}$ and thereby making the initial phase zero, it is possible to obtain the synchronizing signal including the gradient of perpendicular magnetic field only, and the orthogonal signal including the gradient of in-plane magnetic field only.
Next, a case in which the cantilever 11 is inclined by $\theta$ will be described. Output ($\partial F/\partial z$) of the alternating magnetic force signal demodulator 151 in this case can be represented by Formula (10):

$$(\partial F/\partial z) = [\partial(F_z\cos(\theta)+F_x\sin(\theta))/\partial z]$$

$$= [\partial\{m_x(\partial H_z/\partial x) + m_z(\partial H_z/\partial z)\}/\partial z]\cos(\theta)$$

$$+ [\partial\{m_x(\partial H_x/\partial x) + m_z(\partial H_x/\partial z)\}/\partial z]\sin(\theta)$$

$$= [\partial\{m_x(\partial H_x/\partial z) + m_z(\partial H_z/\partial z)\}/\partial z]\cos(\theta)$$

$$+ [\partial\{m_x(\partial H_x/\partial x) + m_z(\partial H_x/\partial z)\}/\partial z]\sin(\theta)$$

$$= m_x\{(\partial^2 H_x/\partial z^2)\cos(\theta) + (\partial^2 H_x/\partial x\partial z)\sin(\theta)\}$$

$$+ m_z\{(\partial^2 H_z/\partial z^2)\cos(\theta) + (\partial^2 H_x/\partial z^2)\sin(\theta)\}$$

$$= m_0\sin(\omega t-\varphi_{04})\{(\partial^2 H_x/\partial z^2)\cos(\theta) + (\partial^2 H_x/\partial x\partial z)\sin(\theta)\}$$

$$+ m_0\cos(\omega t-\varphi_{04})\{(\partial^2 H_z/\partial z^2)\cos(\theta) + (\partial^2 H_x/\partial z^2)\sin(\theta)\}$$

$$= m_0\{\sin(\omega t)\cos(-\varphi_{04}) + \cos(\omega t)\sin(-\varphi_{04})\}$$

$$\{(\partial^2 H_x/\partial z^2)\cos(\theta) + (\partial^2 H_x/\partial x\partial z)\sin(\theta)\}$$

$$+ m_0\{\cos(\omega t)\cos(-\varphi_{04}) - \sin(\omega t)\sin(-\varphi_{04})\}$$

$$\{(\partial^2 H_z/\partial z^2)\cos(\theta) + (\partial^2 H_x/\partial z^2)\sin(\theta)\}$$

$$= \cos(\omega t)[m_0\sin(-\varphi_{04})\{(\partial^2 H_x/\partial z^2)\cos(\theta) + (\partial^2 H_x/\partial x\partial z)\sin(\theta)\}$$

$$+ m_0\cos(-\varphi_{04})\{(\partial^2 H_z/\partial z^2)\cos(\theta) + (\partial^2 H_x/\partial z^2)\sin(\theta)\}]$$

$$+ \sin(\omega t)[m_0\cos(-\varphi_{04})\{(\partial^2 H_x/\partial z^2)\cos(\theta) + (\partial^2 H_x/\partial x\partial z)\sin(\theta)\}$$

$$- m_0\sin(-\varphi_{04})\{(\partial^2 H_z/\partial z^2)\cos(\theta) + (\partial^2 H_x/\partial z^2)\sin(\theta)\}] \quad \ldots (10)$$

The synchronizing signal measured by the demodulated signal processing device 152 (lock-in amplifier) corresponds to:

$$m_0\sin(-\varphi_{04})\{(\partial^2 H_x/\partial z^2)\cos(\theta)+(\partial^2 H_x/\partial x\partial z)\sin(\theta)\}$$

$$+ m_0\cos(-\varphi_{04})\{(\partial^2 H_z/\partial z^2)\cos(\theta)+(\partial^2 H_x/\partial z^2)\sin(\theta)\}$$

The orthogonal signal measured by the demodulated signal processing device 152 (lock-in amplifier) corresponds to:

$$m_0\cos(-\varphi_{04})\{(\partial^2 H_x/\partial z^2)\cos(\theta)+(\partial^2 H_x/\partial x\partial z)\sin(\theta)\}$$

$$- m_0\sin(-\varphi_{04})\{(\partial^2 H_z/\partial z^2)\cos(\theta)+(\partial^2 H_x/\partial z^2)\sin(\theta)\}$$

Therefore, as described above, when $\theta$ is small, the synchronizing signal measured by the demodulated signal processing device 152 (lock-in amplifier) corresponds to:

$$(\partial^2 H_z/\partial z^2)\cos(-\varphi_{04}) + (\partial^2 H_x/\partial z^2)\sin(-\varphi_{04})$$

and the orthogonal signal measured by the lock-in amplifier corresponds to:

$$(\partial^2 H_x/\partial z^2)\cos(-\varphi_{04}) - (\partial^2 H_z/\partial z^2)\sin(-\varphi_{04})$$

The scanning mechanism 16 scans the surface of the specimen 5 by means of the probe 111 of the cantilever 11 (S150). Its scanning speed is slow enough to be ignored when the demodulator 15 demodulates the alternating magnetic force.

While the scanning mechanism 16 scans the surface of the specimen 5 by means of the probe 111 in directions parallel to the surface of the specimen 5, The data storage 17 stores the following at each point of the scanning area of the probe as the initial data (S160):

• the amplitude and delay angle of the demodulated signal (alternating magnetic force signal);
• the synchronizing signal measured by the demodulated signal processing device 152 (lock-in amplifier); and
• the orthogonal signal measured by the demodulated signal processing device 152 (lock-in amplifier).

A set of measurement process of S110 to S160 is carried out to a lot of positions on the surface of the specimen 5 (on the scanning area).

The demodulated signal (alternating magnetic force signal ($\partial F_z/\partial z$) is represented as below:

$$(\partial F_2/\partial z)$$
$$= m_0 \sin(\omega t - \varphi_{04})(\partial^2 H_x/\partial z^2) + m_0 \cos(\omega t - \varphi_{04})(\partial^2 H_z/\partial z^2)$$
$$= m_0 [\{(\partial^2 H_z/\partial z^2)\cos(-\varphi_{04}) + (\partial^2 H_x/\partial z^2)\sin(-\varphi_{04})\}^2$$
$$+ (\partial^2 H_x/\partial z^2)\cos(-\varphi_{04}) - (\partial^2 H_z/\partial z^2)\sin(-\varphi_{04})\}^2]^{1/2}$$
$$\cos(\omega t + \tan^{-1}[\{(\partial^2 H_x/\partial z^2)\cos(-\varphi_{04}) - (\partial^2 H_z/\partial z^2)\sin(-\varphi_{04})\}$$
$$/\{(\partial^2 H_z/\partial z^2)\cos(-\varphi_{04}) + (\partial^2 H_x/\partial z^2)\sin(-\varphi_{04})\}])$$
$$= m_0 [\{(\partial^2 H_z/\partial z^2)\cos(-\varphi_{04}) + (\partial^2 H_x/\partial z^2)\sin(-\varphi_{04})\}^2$$
$$+\{(\partial^2 H_x/\partial z^2)\cos(-\varphi_{04}) - (\partial^2 H_z/\partial z^2)\sin(-\varphi_{04})\}^2]^{1/2}$$
$$\cos(\omega t - \tan^{-1}[\{(\partial^2 H_z/\partial z^2)\sin(-\varphi_{04}) - (\partial^2 H_x/\partial z^2)\cos(-\varphi_{04})\}$$
$$/\{(\partial^2 H_z/\partial z^2)\cos(-\varphi_{04}) + (\partial^2 H_x/\partial z^2)\sin(-\varphi_{04})\}])$$

Therefore, the amplitude of the alternating magnetic force signal ($\partial F_z/\partial z$) is represented as below:

$$= m_0 [\{(\partial^2 H_z/\partial z^2)\cos(-\varphi_{04}) + (\partial^2 H_x/\partial z^2)\sin(-\varphi_{04})\}^2$$
$$+ \{(\partial^2 H_x/\partial z^2)\cos(-\varphi_{04}) - (\partial^2 H_z/\partial z^2)\sin(-\varphi_{04})\}^2]^{1/2}$$

Also, the delay angle of the alternating magnetic force signal ($\partial F_z,\partial z$) is represented as below:

$$\varphi_{03} = \tan^{-1}[\{\partial^2 H_z/\partial z^2\}\sin(-\varphi_{04}) - (\partial^2 H_x/\partial z^2)\cos(-\varphi_{04})\}$$
$$/\{(\partial^2 H_z/\partial z^2)\cos(-\varphi_{04}) + (\partial^2 H_x/\partial z^2)\sin(-\varphi_{04})\}]$$

The synchronizing signal measured by the demodulated signal processing device 152 (lock-in amplifier) is represented as below:

$$(\partial^2 H_z/\partial z^2)\, m_0 \cos(-\varphi_{04}) \;+\; (\partial^2 H_x/\partial z^2)\, m_0 \sin(-\varphi_{04})$$

The orthogonal signal measured by the demodulated signal processing device 152 (lock-in amplifier) is represented as below:

$$(\partial^2 H_x/\partial z^2)\, m_0 \cos(-\varphi_{04}) \;-\; (\partial^2 H_z/\partial z^2)\, m_0 \sin(-\varphi_{04})$$

The modulated data generator 18 recalls

(a) the amplitude and delay angle $\varphi_{03}$ of the initial data $(\partial F_z/\partial z)$,
(b) the synchronizing signal and the orthogonal signal

$$(\partial^2 H_z/\partial z^2)\, m_0 \cos(-\varphi_{04}) \;+\; (\partial^2 H_x/\partial z^2)\, m_0 \sin(-\varphi_{04}),$$

$$(\partial^2 H_x/\partial z^2)\, m_0 \cos(-\varphi_{04}) \;-\; (\partial^2 H_z/\partial z^2)\, m_0 \sin(-\varphi_{04})$$

which are stored in the data storage 17, and generates a lot of data by modifying (increasing or decreasing) the phase $\varphi$ of the initial data (S170).

The image display device 19 displays an image of magnetic field distribution according to the initial data stored in the data storage 17 and an image of magnetic field distribution according to the data in which the phase $\varphi$ of the initial data has been modified for each coordinate of the scanning area (S180).

For example, range of brightness (density or luminance) is supposed to have 2N+1 steps from 0 that is the minimum to 2N (N is a positive integer) that is the maximum. Defining the brightness as "2N" when the intensity of the magnetic field is maximum upward, as "N" when the intensity of the magnetic field is zero, and as "0" when the intensity of the magnetic field is maximum downward, and allocating the 2N+1 steps of the brightness to the intensity of the magnetic field including direction, the image of magnetic field distribution is generated.

By observing the image of magnetic field distribution visually or by software, it is possible to obtain the magnetic profile (in specific, magnetization state) of the specimen 5 (S190).

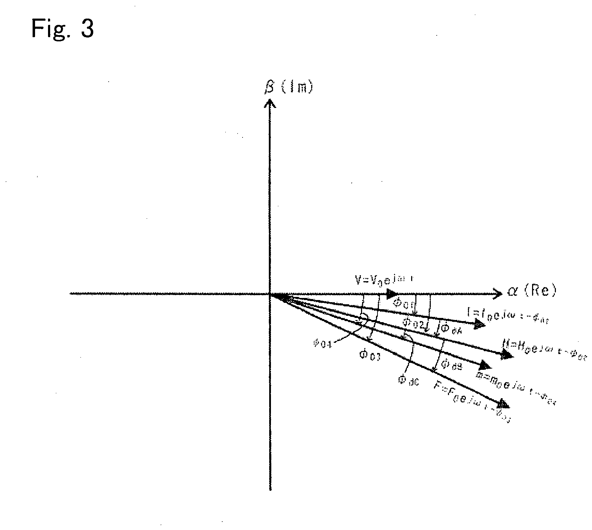

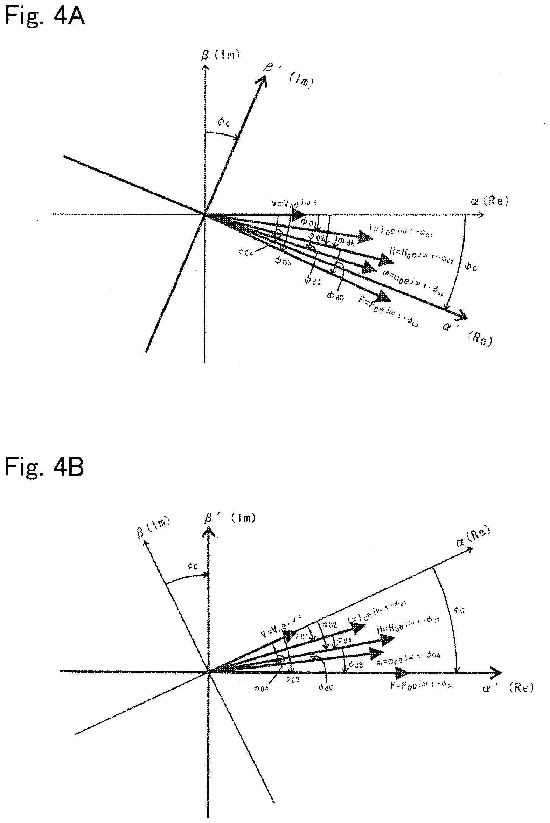

Figs. 3 and 4 are figures for supplemental explanation illustrating the process described above.

A vector diagram shown by $\alpha$-$\beta$ coordinate system in Fig. 3 shows a phase before a process by means of the modified data generator 18 is carried out.

In Fig.3, a magnetic force gradient vector is represented by Formula (11):

$$\alpha_1 + j\beta_1 = \{(\partial^2 H_z/\partial z^2)\cos(-\varphi_{04}) + (\partial^2 H_x/\partial z^2)\sin(-\varphi_{04})\}$$
$$+ j\{(\partial^2 H_x/\partial z^2)\cos(-\varphi_{04}) - (\partial^2 H_z/\partial z^2)\sin(-\varphi_{04})\}$$

that is,

$$\alpha_1 = (\partial^2 H_z/\partial z^2)\cos(-\varphi_{04}) + (\partial^2 H_x/\partial z^2)\sin(-\varphi_{04})$$

$$\beta_1 = -(\partial^2 H_z/\partial z^2)\sin(-\varphi_{04}) + (\partial^2 H_x/\partial z^2)\cos(-\varphi_{04}) \quad \ldots (11)$$

A vector diagram shown by $\alpha'$-$\beta'$ coordinate system in Fig. 4A is a diagram in which the $\alpha$-$\beta$ coordinate system in Fig. 3 is rotated, and the modified data generator 18 adjusts the initial phase to zero by adding a correction phase $\varphi_C$ to the phase $-\varphi_{04}$ in Formula (11).

In the $\alpha'$-$\beta'$ coordinate system, the magnetic force gradient vector in the same direction as the magnetization m vector of the probe 111 is represented by Formula (12):

$$\alpha_1' + j\beta_1' = \{(\partial^2 H_z/\partial z^2)\cos(-\varphi_{04}+\varphi_C) + (\partial^2 H_x/\partial z^2)\sin(-\varphi_{04}+\varphi_C)\}$$

$$+ j\{-(\partial^2 H_z/\partial z^2)\sin(-\varphi_{04}+\varphi_C) + (\partial^2 H_x/\partial z^2)\cos(-\varphi_{04}+\varphi_C)\}$$

that is,

$$\alpha_1' = (\partial^2 H_z/\partial z^2)\cos(-\varphi_{04}+\varphi_C) + (\partial^2 H_x/\partial z^2)\sin(-\varphi_{04}+\varphi_C)$$

$$\beta_1' = -(\partial^2 H_z/\partial z^2)\sin(-\varphi_{04}+\varphi_C) + (\partial^2 H_x/\partial z^2)\cos(-\varphi_{04}+\varphi_C) \quad \ldots(12)$$

Therefore, as shown in Fig. 4B, the condition for the initial phase of the magnetic force gradient vector to be zero in the $\alpha'$-$\beta'$ coordinate system is represented by Formula (13):

$$\varphi_C = \varphi_{04} \quad \ldots(13)$$

In this case, $\alpha_1'$ corresponds only to a perpendicular magnetic field gradient:

$$\alpha_1' = (\partial^2 H_z/\partial z^2)$$

Further, when the phase is shifted forward by 90° as $\varphi_C = \varphi_{04} + 90°$, $\alpha_1'$ corresponds only to an in-plane magnetic field gradient.

$$\alpha_1' = (\partial^2 H_x/\partial z^2)$$

An operator obtains the condition of Formula (13), without using the modified data generator 18, by: firstly, generating an image of magnetic field distribution of the phase $\varphi_{04}$ from the initial data stored in the data storage 17; then modifying the correction phase $\varphi_C$ while visually observing the image (or, modifying the correction phase $\varphi_C$ while observing the image of the magnetic field distribution by software;, and finding out an image having maximum brightness (or an image having minimum brightness). Here, as the correction of $\varphi_{04}$, by using an specimen having a known magnetization state such as a perpendicular magnetic recording medium having a low recording density as a standard specimen and adjusting the phase at a position where only a perpendicular magnetic field or a position where only an in-plane magnetic field occurs, it is possible to measure a magnetic profile with a high accuracy.

In the above example, a phase of the magnetic field H at the position of the probe 111 is identified by finding out an image having maximum brightness (or an image having minimum brightness) . However, it is also possible to identify the phase (and amplitude) of the magnetic field at the position of the probe 111 by finding out an image of magnetic field distribution having maximum brightness difference, or by finding out an image of magnetic field distribution having minimum brightness difference.

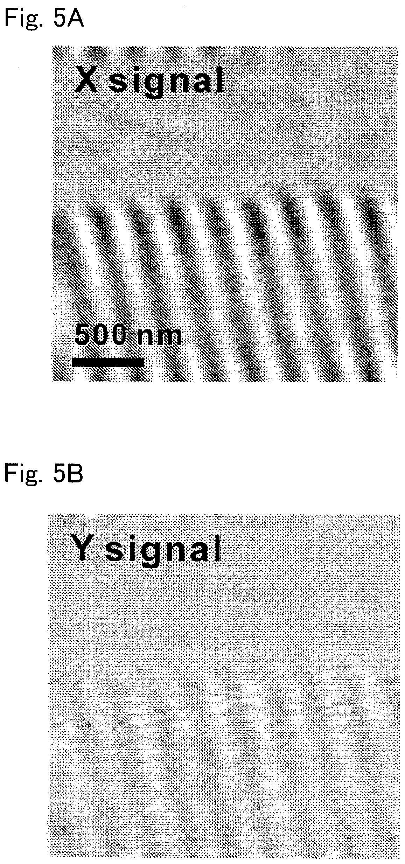

Figs. 5A and 5B show respective examples of an image of perpendicular magnetic field distribution and an image of in-plane magnetic field distribution on a surface of a hard disc having indefinite phase, stored in the data storage 17.

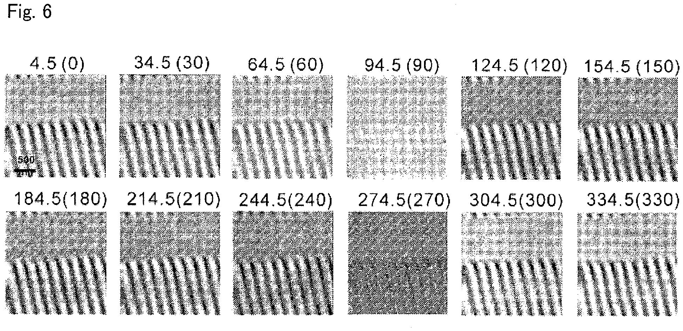

Fig. 6 shows examples of images of magnetic field distribution on the surface of the hard disk with their phases modified, wherein the images have been generated from the images of Fig. 5A and 5B (data stored in the data storage 17).

Fig. 6 shows twelve images of magnetic field distribution corresponding to component of $\alpha'$ coordinate with their phases being modified stepwise by 30° per each, after adjusting the phase so that the phase becomes zero when magnetic intensity becomes maximum at a central portion of recording bit of a perpendicular magnetic recording medium (only a perpendicular magnetic field occurs) that is a specimen. For each of the images of magnetic field distribution, phase values are noted. Phases based on the phase of the alternating voltage V (see Formula (1)) are noted, and phases in the above-described $\alpha'$-$\beta'$-coordinate system are noted in parentheses.

As described above, an image of perpendicular magnetic field and an image of in-plane magnetic field can be obtained by modifying the correction phase ($\varphi_C$) while visually observing the images of magnetic field distribution displayed in the image display device 19 (or, modifying the correction phase ($\varphi_C$) while observing the images of magnetic field distribution by software). In Fig. 6, the phase with which an image of perpendicular magnetic field can be obtained is 4.5°, and the phase in the $\alpha'$-$\beta'$ coordinate system such that the correction angle becomes -4.5° is shown in each parenthesis.

Images with phase difference described in parentheses of 0° and 180°correspond to images of perpendicular magnetic field, and images with phase difference described in parentheses of 90° and 270° correspond to images of in-plane magnetic field.

Description of the Reference Numerals

| | |
|---|---|
| 1 | magnetic profile measuring device |
| 5, 82, 93 | specimen |
| 11, 81, 91 | cantilever |
| 12 | driver |
| 13, 92 | alternating-current magnetic field generator |
| 14 | vibration sensor |
| 15 | demodulator |
| 16 | scanning mechanism |
| 17 | data storage |
| 18 | modified data generator |
| 19 | image display device |
| 111, 811, 911 | probe |
| 121, 812, 912 | piezoelectric element |
| 122 | power source |
| 131 | signal generator |
| 132 | coil main body |
| 141 | laser |
| 142 | photodiode |
| 151 | alternating magnetic force signal demodulator |
| 152 | demodulated signal processing device |

**Claims**

1.  A magnetic profile measuring device (1) which scans a scanning area on a surface of a specimen (5; 82; 93) by means of a magnetized probe (111; 811; 911) on a tip of a driven cantilever (11; 81; 91), detects vibration of the cantilever (11; 81; 91), and generates an image of magnetic field distribution of the scanning area based on results of the detection, the device (1) comprising:

    the cantilever (11; 81; 91) wherein the probe (111; 811; 911) is equipped on the tip of the cantilever (11; 81; 91);
    a driver (12) driving the cantilever (11; 81; 91) at a resonant frequency of the cantilever (11; 81; 91) or at a frequency close to the resonant frequency of the cantilever (11; 81; 91);
    an alternating-current magnetic field generator (13; 92) generating an alternating-current magnetic field and periodically reversing the magnetic polarity of the probe (111; 811; 911), and thereby modulating driven vibration of the cantilever (11; 81; 91) by frequency or by both frequency and amplitude;
    a vibration sensor (14) detecting vibration of the probe (111; 811; 911);
    a demodulator (15) demodulating from a detection signal of the vibration sensor (14) a magnetic signal which corresponds to an alternating magnetic force occurring between the probe (111; 811; 911) and the specimen (5; 82; 93), and detecting the demodulated magnetic signal as (A) two separate signal components having phase difference of 90° and being orthogonal to each other or (B) amplitude and a phase of the magnetic field at the position of the probe (111; 811; 911);
    a scanning mechanism (16) scanning the scanning area by means of the probe (111; 811; 911);
    a data storage (17) storing an initial data for each coordinate of the scanning area wherein the initial data is (A) the two separate signal components orthogonal to each other or (B) the amplitude and phase of the magnetic field, and wherein the initial data is obtained by scanning the scanning area by means of the scanning mechanism (16) on condition that the demodulation is synchronized with operation of the alternating-current magnetic field generator (13; 92);

**characterized in that** the device further comprises:

a modified data generator (18) recalling the initial data from the data storage (17) and generating a plurality of data by modifying the phase of the initial data by a correction phase $\varphi_c$; and
an image display device (19) displaying an image of magnetic field distribution based on data generated for each coordinate of the scanning area by the modified data generator (18);
and **in that** the device is so configured that the image of magnetic field distribution is generated by allocating brightness to intensity of the magnetic field including direction; and
the correction phase $\varphi_c$ that adjusts the phase of the initial data to zero is obtained by:

modifying the correction phase,
finding out an image of magnetic field distribution having maximum or minimum brightness,
using a specimen having a known magnetization state, and
adjusting the phase of the initial data at a position where only a perpendicular magnetic field or a position where only an in-plane magnetic field occurs.

2. The magnetic profile measuring device (1) according to claim 1, wherein
where the magnetic field at the position of the probe (111; 811; 911) is represented by

$$H_\alpha \; + \; jH_\beta \; \equiv \; H_0 exp(j\varphi)$$

in $\alpha$-$\beta$ complex plane which is Gauss plane;
amplitude of the magnetic field at the position of the probe (111; 811; 911), $H_0$, is represented by

$$H_0 \; \equiv \; (H_\alpha{}^2 \; + \; H_\beta{}^2)^{1/2}$$

which is a distance from the origin in the $\alpha$-$\beta$ complex plane;
the phase of the magnetic field at the position of the probe (111; 811; 911), $\varphi$, is represented by

$$\varphi \; \equiv \; tan^{-1}(H_\beta/H_\alpha)$$

which is an argument $\varphi$ in the $\alpha$-$\beta$ complex plane;
$\alpha$-component of the magnetic field at the position of the probe (111; 811; 911) is represented by

$$H_\alpha \; = \; H_0 cos\varphi$$

which is a component parallel to the $\alpha$-axis; and
$\beta$-component of the magnetic field at the position of the probe (111; 811; 911) is represented by

$$H_\beta \; = \; H_0 cos\varphi$$

which is a component parallel to the $\beta$-axis perpendicular to the $\alpha$-axis,
the demodulator (15) detects the demodulated magnetic signal as (A) a data pair of the $\alpha$-component and the $\beta$-component ($H_\alpha$, $H_\beta$) or (B) a data pair of the amplitude and the phase ($H_0$, $\varphi$).

3. The magnetic profile measuring device (1) according to claim 2, wherein
either (X) the $\alpha$-component is a perpendicular magnetic field component of the magnetic field wherein the perpendicular magnetic field component is a component perpendicular to the surface of the specimen (5; 82; 93); and the $\beta$-component is an in-plane magnetic field component of the magnetic field wherein the in-plane magnetic field component is a component parallel to the surface of the specimen (5; 82; 93),
or (Y) the $\alpha$-component is an in-plane magnetic field component of the magnetic field wherein the in-plane magnetic field component is a component parallel to the surface of the specimen (5; 82; 93); and the $\beta$-component is a

perpendicular magnetic field component of the magnetic field wherein the perpendicular magnetic field component is a component perpendicular to the surface of the specimen (5; 82; 93).

4. The magnetic profile measuring device according to claim 2 or 3, wherein the magnetic field at the position of the probe (111; 811; 911) is displayed by means of the image display device (19) by making the α-component and/or the β-component into an image depending on variation of the argument φ.

5. A method for measuring magnetic profile including scanning a scanning area on a surface of a specimen (5; 82; 93) by means of a magnetized probe (111; 811; 911) on a tip of a driven cantilever (11; 81; 91), detecting vibration of the cantilever (11; 81; 91), and generating an image of magnetic field distribution of the scanning area based on results of the detection, the method comprising the steps of:

driving (S110) the cantilever (11; 81; 91) at a resonant frequency of the cantilever (11; 81; 91) or at a frequency close to the resonant frequency of the cantilever (11; 81; 91), wherein the probe (111; 811; 911) is equipped on the tip of the cantilever (11; 81; 91);
generating (S120) an alternating-current magnetic field and periodically reversing the magnetic polarity of the probe (111; 811; 911), and thereby modulating driven vibration of the cantilever (11; 81; 91) by frequency;
detecting (S130) vibration of the probe (111; 811; 911) and demodulating from the detection signal a magnetic signal which corresponds to an alternating magnetic force occurring between the probe (111; 811; 911) and the specimen (5; 82; 93);
detecting (S140) the demodulated magnetic signal as (A) two separate signal components which have phase difference of 90° and are orthogonal to each other or (B) amplitude and a phase of the magnetic field at the position of the probe (111; 811; 911);
scanning (S150) the scanning area by means of the probe (111; 811; 911);
storing (S160) an initial data in a data storage (17) for each coordinate of the scanning area wherein the initial data is (A) the two separate signal components orthogonal to each other or (B) the amplitude and phase of the magnetic field, and wherein the initial data is obtained by scanning the scanning area on condition that the demodulation is synchronized with the generation of the alternating-current magnetic field; **characterized in that** the method further comprises the steps of:
recalling (S170) the initial data from the data storage (17) and generating a plurality of data by modifying the phase of the initial data by a correction phase $\varphi_c$;
displaying (S180) an image of a magnetic field distribution based on data generated by modifying the phase of the initial data, on a image display device (19); and
measuring (S190) the magnetic profile of the specimen (5; 82; 93) based on each image of magnetic field distribution displayed on the image display device (19);
wherein the image of magnetic field distribution is generated by allocating brightness to intensity of the magnetic field including direction; and
the correction phase ($\varphi_c$ that adjusts the phase of the initial data to zero is obtained by:

modifying the correction phase,
finding out an image of magnetic field distribution having maximum or minimum brightness,
using a specimen having a known magnetization state, and
adjusting the phase of the initial data at a position where only a perpendicular magnetic field or a position where only an in-plane magnetic field occurs.

6. The method for measuring magnetic profile according to claim 5, wherein in the step of detecting (S140) the demodulated magnetic signal, where the magnetic field at the position of the probe (111; 811; 911) is represented by

$$H_\alpha + jH_\beta \equiv H_0 \exp(j\varphi)$$

in α-β complex plane which is Gauss plane;
amplitude of the magnetic field at the position of the probe (111; 811; 911), Ho, is represented by

$$H_0 \equiv (H_\alpha^2 + H_\beta^2)^{1/2}$$

which is a distance from the origin in the $\alpha$-$\beta$ complex plane;
the phase of the magnetic field at the position of the probe (111; 811; 911), $\varphi$, is represented by

$$\varphi \equiv \tan^{-1}(H_\beta/H_\alpha)$$

which is an argument $\varphi$ in the $\alpha$-$\beta$ complex plane;
$\alpha$-component of the magnetic field at the position of the probe (111; 811; 911) is represented by

$$H_\alpha = H_0\cos\varphi$$

which is a component parallel to the $\alpha$-axis; and
$\beta$-component of the magnetic field at the position of the probe (111; 811; 911) is represented by

$$H_\beta = H_0\cos\varphi$$

which is a component parallel to the $\beta$-axis perpendicular to the $\alpha$-axis,
the demodulated magnetic signal is detected as (A) a data pair of the $\alpha$-component and the $\beta$-component ($H_\alpha$, $H_\beta$) or (B) a data pair of the amplitude and the phase ($H_0$, $\varphi$).

7.  The method for measuring magnetic profile according to claim 6, wherein
either (X) the $\alpha$-component is a perpendicular magnetic field component of the magnetic field wherein the perpendicular magnetic field component is a component perpendicular to the surface of the specimen (5; 82; 93); and the $\beta$-component is an in-plane magnetic field component of the magnetic field wherein the in-plane magnetic field component is a component parallel to the surface of the specimen (5; 82; 93),
or (Y) the $\alpha$-component is an in-plane magnetic field component of the magnetic field wherein the in-plane magnetic field component is a component parallel to the surface of the specimen (5; 82; 93); and the $\beta$-component is a perpendicular magnetic field component of the magnetic field wherein the perpendicular magnetic field component is a component perpendicular to the surface of the specimen (5; 82; 93).

8.  The method for measuring magnetic profile according to claim 6 or 7,
wherein the magnetic field at the position of the probe (111; 811; 911) is displayed by means of the image display device (19) by making the $\alpha$-component and/or the $\beta$-component into an image depending on variation of the argument $\varphi$.

**Patentansprüche**

1.  Eine Magnetprofilmessvorrichtung (1), die einen Abtastbereich auf einer Oberfläche eines Prüflings (5; 82; 93) mittels einer magnetisierten Sonde (111; 811; 911) auf einer Spitze eines angetriebenen Auslegers (11; 81; 91) abtastet, Vibrationen des Auslegers (11; 81; 91) erfasst und basierend auf den Ergebnissen der Erfassung ein Bild der Magnetfeldverteilung der Abtastfläche erzeugt, wobei die Vorrichtung (1) Folgendes umfasst:

den Ausleger (11; 81; 91), wobei die Spitze des Auslegers (11; 81; 91) mit der Sonde (111; 811; 911) versehen ist;
einen Treiber oder Antrieb (12), der den Ausleger (11; 81; 91) mit einer Resonanzfrequenz des Auslegers (11; 81; 91) oder mit einer Frequenz nahe der Resonanzfrequenz des Auslegers (11; 81; 91) antreibt;
einen Wechselstrom-Magnetfeldgenerator (13; 92), der ein Wechselstrommagnetfeld erzeugt und die Magnetpolarität der Sonde (111; 811; 911) periodisch umkehrt und dadurch die angetriebene Vibration des Auslegers (11; 81; 91) durch Frequenz oder durch Frequenz und Amplitude moduliert;
einen Vibrationssensor (14), der die Vibration der Sonde (111; 811; 911) erfasst;
einen Demodulator (15), der ausgehend von einem Detektionssignal des Schwingungssensors (14) ein Magnetsignal demoduliert, das einer magnetischen Wechselkraft entspricht, die zwischen der Sonde (111; 811; 911) und dem Prüfling (5; 82; 93) auftritt, und der das demodulierte Magnetsignal als (A) zwei separate Signalkomponenten die eine Phasendifferenz von 90° aufweisen und orthogonal zueinander sind oder als (B) Amplitude und eine Phase des Magnetfeldes an der Position der Sonde (111; 811; 911) erfasst;

einen Abtastmechanismus (16), der den Abtastbereich mit Hilfe der Sonde (111; 811; 911) abtastet;
einen Datenspeicher (17), der Anfangsdaten für jede Koordinate des Abtastbereichs speichert, wobei die Anfangsdaten (A) die beiden separaten, zueinander orthogonalen Signalkomponenten oder (B) die Amplitude und Phase des Magnetfeldes sind, und wobei die Anfangsdaten durch Abtasten des Abtastbereichs mittels des Abtastmechanismus (16) erhalten werden, unter der Voraussetzung, dass die Demodulation mit dem Betrieb des Wechselstrommagnetfeldgenerators (13; 92) synchronisiert ist;
**dadurch gekennzeichnet, dass** die Vorrichtung ferner Folgendes umfasst:

einen modifizierten Datengenerator (18), der die Anfangsdaten aus dem Datenspeicher (17) abruft und eine Vielzahl von Daten erzeugt, indem er die Phase der Anfangsdaten durch eine Korrekturphase $\varphi c$ modifiziert; und
eine Bildanzeigevorrichtung (19), die ein Bild der Magnetfeldverteilung anzeigt, basierend auf Daten, die durch den modifizierten Datengenerator (18) für jede Koordinate des Abtastbereichs erzeugt werden,

**und dadurch, dass** die Vorrichtung so konfiguriert ist, dass das Bild der Magnetfeldverteilung durch Zuordnen der Helligkeit zur Intensität des Magnetfeldes einschließlich der Richtung erzeugt wird; und
die Korrekturphase $\varphi c$, die die Phase der Anfangsdaten auf null einstellt, durch Folgendes erhalten wird:

Modifizieren der Korrekturphase,
Ausfindig machen eines Bildes der Magnetfeldverteilung mit maximaler oder minimaler Helligkeit,
Verwenden eines Prüflings mit einem bekannten Magnetisierungszustand und
Einstellen der Phase der Anfangsdaten an einer Position, an der nur ein senkrechtes Magnetfeld oder an einer Position, an der nur ein *in-plane* Magnetfeld auftritt.

2. Die Magnetprofilmessvorrichtung (1) nach Anspruch 1, wobei wo das Magnetfeld an der Position der Sonde (111; 811; 911) dargestellt wird durch

$$H_\alpha + jH_\beta \equiv H_0 \exp(j\varphi)$$

in einer komplexen Ebene $\alpha$-$\beta$, die die Gauß-Ebene ist;
die Amplitude des Magnetfeldes an der Position der Sonde (111; 811; 911), $H_0$, dargestellt wird durch:

$$H_0 \equiv (H_\alpha{}^2 + H_\beta{}^2)^{1/2}$$

was ein Abstand vom Ursprung in der komplexen Ebene $\alpha$-$\beta$ ist;
die Phase des Magnetfeldes an der Position der Sonde (111; 811; 911), $\varphi$, dargestellt wird durch:

$$\varphi \equiv \tan^{-1}(H_\beta / H_\alpha)$$

was ein Argument $\varphi$ in der komplexen Ebene $\alpha$-$\beta$ ist;
die $\alpha$-Komponente des Magnetfeldes an der Position der Sonde (111; 811; 911) dargestellt wird durch

$$H_\alpha = H_0 \cos \varphi$$

die eine Komponente parallel zur $\alpha$-Achse ist; und wo
die $\beta$-Komponente des Magnetfeldes an der Position der Sonde (111; 811; 911) dargestellt wird durch

$$H_\beta = H_0 \cos \varphi$$

die eine Komponente parallel zur $\beta$-Achse senkrecht zur $\alpha$-Achse ist,
der Demodulator (15) das demodulierte Magnetsignal als (A) ein Datenpaar aus $\alpha$-Komponente und $\beta$-Komponente ($H_\alpha$, $H_\beta$) oder als (B) ein Datenpaar aus Amplitude und Phase ($H_0$, $\varphi$) erfasst.

**3.** Die Magnetprofilmessvorrichtung (1) nach Anspruch 2, wobei
entweder (X) die $\alpha$-Komponente eine senkrechte Magnetfeldkomponente des Magnetfeldes ist, wobei die senkrechte Magnetfeldkomponente eine Komponente senkrecht zur Oberfläche des Prüflings (5; 82; 93) ist; und die $\beta$-Komponente eine *in-plane* Magnetfeldkomponente des Magnetfeldes ist, wobei die *in-plane* Magnetfeldkomponente eine Komponente parallel zur Oberfläche des Prüflings (5; 82; 93) ist,
oder (Y) die $\alpha$-Komponente eine *in-plane* Magnetfeldkomponente des Magnetfeldes ist, wobei die *in-plane* Magnetfeldkomponente eine Komponente parallel zur Oberfläche des Prüflings (5; 82; 93) ist; und die $\beta$-Komponente eine senkrechte Magnetfeldkomponente des Magnetfeldes ist, wobei die senkrechte Magnetfeldkomponente eine Komponente senkrecht zur Oberfläche des Prüflings (5; 82; 93) ist.

**4.** Die Magnetprofilmessvorrichtung nach Anspruch 2 oder 3,
wobei das Magnetfeld an der Position der Sonde (111; 811; 911) mittels der Bildanzeigevorrichtung (19) angezeigt wird, indem die $\alpha$-Komponente und/oder die $\beta$-Komponente in Abhängigkeit von der Variation des Arguments $\varphi$ zu einem Bild gemacht wird.

**5.** Ein Verfahren zum Messen eines Magnetprofils, beinhaltend das Abtasten eines Abtastbereichs auf einer Oberfläche eines Prüflings (5; 82; 93) mittels einer magnetisierten Sonde (111; 811; 911) an einer Spitze eines angetriebenen Auslegers (11; 81; 91), das Erfassen von Vibrationen des Auslegers (11; 81; 91) und das Erzeugen eines Bildes der Magnetfeldverteilung der Abtastfläche basierend auf Ergebnissen der Erfassung, wobei das Verfahren die folgenden Schritte umfasst:

Antreiben (S110) des Auslegers (11; 81; 91) mit einer Resonanzfrequenz des Auslegers (11; 81; 91) oder mit einer Frequenz nahe der Resonanzfrequenz des Auslegers (11; 81; 91), wobei die Sonde (111; 811; 911) an der Spitze des Auslegers (11; 81; 91) bereitgestellt wird;
Erzeugen (S120) eines Wechselstrommagnetfeldes und periodisches Umkehren der magnetischen Polarität der Sonde (111; 811; 911) und dadurch Modulieren der angetriebenen Vibration des Auslegers (11; 81; 91) durch Frequenz;
Erfassen (S130) von Vibrationen der Sonde (111; 811; 911) und Demodulieren eines Magnetsignals ausgehend vom Detektionssignal, das einer magnetischen Wechselkraft entspricht, die zwischen der Sonde (111; 811; 911) und dem Prüfling (5; 82; 93) auftritt;
Erfassen (S140) des demodulierten Magnetsignals als (A) zwei getrennte Signalkomponenten, die eine Phasendifferenz von 90° aufweisen und orthogonal zueinander sind, oder als (B) Amplitude und eine Phase des Magnetfeldes an der Position der Sonde (111; 811; 911);
Abtasten (S150) der Abtastfläche mit Hilfe der Sonde (111; 811; 911);
Speichern (S160) von Anfangsdaten in einem Datenspeicher (17) für jede Koordinate des Abtastbereichs, wobei die Anfangsdaten (A) die beiden separaten, zueinander orthogonalen Signalkomponenten oder (B) die Amplitude und Phase des Magnetfeldes sind, und wobei die Anfangsdaten durch Abtasten des Abtastbereichs unter der Bedingung erhalten werden, dass die Demodulation mit der Erzeugung des Wechselstrommagnetfeldes synchronisiert ist;
**dadurch gekennzeichnet, dass** das Verfahren ferner die folgenden Schritte umfasst:

Abrufen (S170) der Anfangsdaten aus dem Datenspeicher (17) und Erzeugen einer Vielzahl von Daten durch Modifizieren der Phase der Anfangsdaten durch eine Korrekturphase $\varphi c$;
Anzeigen (S180) eines Bildes einer Magnetfeldverteilung auf einer Bildanzeigevorrichtung (19) basierend auf Daten, die durch Modifizieren der Phase der Anfangsdaten erzeugt wurden; und
Messen (S190) des Magnetprofils des Prüflings (5; 82; 93) basierend auf jedem Bild der Magnetfeldverteilung, das auf der Bildanzeigevorrichtung (19) angezeigt wird;

wobei das Bild der Magnetfeldverteilung erzeugt wird, indem die Helligkeit der Intensität des Magnetfeldes einschließlich der Richtung zugeordnet wird; und wobei
die Korrekturphase $\varphi c$, die die Phase der Anfangsdaten auf null einstellt, durch Folgendes erhalten wird:

Modifizieren der Korrekturphase,
Ausfindig machen eines Bildes der Magnetfeldverteilung mit maximaler oder minimaler Helligkeit,
Verwenden eines Prüflings mit einem bekannten Magnetisierungszustand und
Einstellen der Phase der Anfangsdaten an einer Position, an der nur ein senkrechtes Magnetfeld oder an einer Position, an der nur ein *in-plane* Magnetfeld auftritt.

6. Das Verfahren zum Messen eines Magnetprofils nach Anspruch 5, wobei im Schritt des Erfassens (S140) des demodulierten Magnetsignals,
wo das Magnetfeld an der Position der Sonde (111; 811; 911) dargestellt wird durch

$$H_\alpha + jH_\beta \equiv H_0 \exp(j\varphi)$$

in einer komplexen Ebene $\alpha$-$\beta$, die die Gauß-Ebene ist;
die Amplitude des Magnetfeldes an der Position der Sonde (111; 811; 911), Ho, dargestellt wird durch:

$$H_0 \equiv (H_\alpha^2 + H_\beta^2)^{1/2}$$

was ein Abstand vom Ursprung in der komplexen Ebene $\alpha$-$\beta$ ist;
die Phase des Magnetfeldes an der Position der Sonde (111; 811; 911), $\varphi$, dargestellt wird durch:

$$\varphi \equiv \tan^{-1}(H_\beta / H_\alpha)$$

was ein Argument $\varphi$ in der komplexen Ebene $\alpha$-$\beta$ ist;
die $\alpha$-Komponente des Magnetfeldes an der Position der Sonde (111; 811; 911) dargestellt wird durch

$$H_\alpha = H_0 \cos \varphi$$

die eine Komponente parallel zur $\alpha$-Achse ist; und wo
die $\beta$-Komponente des Magnetfeldes an der Position der Sonde (111; 811; 911) dargestellt wird durch

$$H_\beta = H_0 \cos \varphi$$

die eine Komponente parallel zur $\beta$-Achse senkrecht zur $\alpha$-Achse ist,
das demodulierte Magnetsignal erfasst wird als (A) ein Datenpaar aus $\alpha$-Komponente und $\beta$-Komponente ($H_\alpha$, $H_\beta$) oder als (B) ein Datenpaar aus Amplitude und Phase ($H_0$, $\varphi$).

7. Das Verfahren zum Messen eines Magnetprofils nach Anspruch 6, wobei
entweder (X) die $\alpha$-Komponente eine senkrechte Magnetfeldkomponente des Magnetfeldes ist, wobei die senkrechte Magnetfeldkomponente eine Komponente senkrecht zur Oberfläche des Prüflings (5; 82; 93) ist; und die $\beta$-Komponente eine *in-plane* Magnetfeldkomponente des Magnetfeldes ist, wobei die *in-plane* Magnetfeldkomponente eine Komponente parallel zur Oberfläche des Prüflings (5; 82; 93) ist,
oder (Y) die $\alpha$-Komponente eine *in-plane* Magnetfeldkomponente des Magnetfeldes ist, wobei die *in-plane* Magnetfeldkomponente eine Komponente parallel zur Oberfläche des Prüflings (5; 82; 93) ist; und die $\beta$-Komponente eine senkrechte Magnetfeldkomponente des Magnetfeldes ist, wobei die senkrechte Magnetfeldkomponente eine Komponente senkrecht zur Oberfläche des Prüflings (5; 82; 93) ist.

8. Das Verfahren zum Messen eines Magnetprofils nach Anspruch 6 oder 7,
wobei das Magnetfeld an der Position der Sonde (111; 811; 911) mittels der Bildanzeigevorrichtung (19) angezeigt wird, indem die $\alpha$-Komponente und/oder die $\beta$-Komponente in Abhängigkeit von der Variation des Arguments $\varphi$ zu einem Bild gemacht wird.

## Revendications

1. Un dispositif de mesure de profil magnétique (1) qui balaie une zone de balayage sur une surface d'un échantillon (5 ; 82 ; 93) au moyen d'une sonde magnétisée (111 ; 811 ; 911) sur une pointe d'un élément en porte-à-faux entraîné (11 ; 81 ; 91), détecte les vibrations de l'élément en porte-à-faux (11 ; 81 ; 91), et génère une image de la distribution du champ magnétique de la zone de balayage en fonction des résultats de la détection, le dispositif (1) comprenant :

l'élément en porte-à-faux (11 ; 81 ; 91), sachant que la sonde (111 ; 811 ; 911) est équipée sur la pointe de l'élément en porte-à-faux (11 ; 81 ; 91) ;
un élément d'entraînement (12) entraînant l'élément en porte-à-faux (11 ; 81 ; 91) à une fréquence de résonance de l'élément en porte-à-faux (11 ; 81 ; 91) ou à une fréquence proche de la fréquence de résonance de l'élément en porte-à-faux (11 ; 81 ; 91);
un générateur de champ magnétique à courant alternatif (13 ; 92) générant un champ magnétique à courant alternatif, et inversant périodiquement la polarité magnétique de la sonde (111 ; 811 ; 911), et modulant ainsi la vibration entraînée de l'élément en porte-à-faux (11 ; 81 ; 91) par fréquence ou par fréquence et amplitude ;
un capteur de vibrations (14) détectant les vibrations de la sonde (111 ; 811 ; 911);
un démodulateur (15) démodulant à partir d'un signal de détection du capteur de vibrations (14) un signal magnétique qui correspond à une force magnétique alternée qui se produit entre la sonde (111 ; 811 ; 911) et l'échantillon (5 ; 82 ; 93), et détectant le signal magnétique démodulé sous la forme (A) de deux composantes distinctes de signal ayant une différence de phase de 90° et étant perpendiculaires entre elles ou sous la forme (B) d'une amplitude et d'une phase du champ magnétique à la position de la sonde (111 ; 811 ; 911) ;
un mécanisme de balayage (16) balayant la zone de balayage au moyen de la sonde (111 ; 811 ; 911);
une mémoire de données (17) stockant des données initiales pour chaque coordonnée de la zone de balayage, sachant que les données initiales sont (A) les deux composantes de signal distinctes et orthogonales l'une par rapport à l'autre ou (B) l'amplitude et la phase du champ magnétique, et sachant que les données initiales sont obtenues par balayage de la zone de balayage au moyen du mécanisme de balayage (16) à condition que la démodulation soit synchronisée avec le fonctionnement du générateur de champ magnétique à courant alternatif (13 ; 92) ;
**caractérisé en ce que** le dispositif comprend en outre :

un générateur de données modifié (18) rappelant les données initiales depuis la mémoire de données (17) et générant une pluralité de données en modifiant la phase des données initiales par une phase de correction $\varphi c$; et
un dispositif d'affichage d'image (19) affichant une image de la distribution de champ magnétique basée sur des données générées pour chaque coordonnée de la zone de balayage par le générateur de données modifié (18) ;

et **en ce que** le dispositif est configuré de telle sorte que l'image de la distribution de champ magnétique est générée en attribuant une luminosité à l'intensité du champ magnétique incluant la direction ; et que
la phase de correction $\varphi c$ qui ajuste la phase des données initiales à zéro est obtenue par le fait de :

modifier la phase de correction,
découvrir une image de distribution de champ magnétique ayant une luminosité maximale ou minimale,
utiliser un spécimen ayant un état de magnétisation connu, et
ajuster la phase des données initiales à un endroit où seul un champ magnétique perpendiculaire ou un endroit où seul un champ magnétique dans le plan (*in-plane*) se produit.

2. Le dispositif de mesure de profil magnétique (1) selon la revendication 1, sachant que
où le champ magnétique à la position de la sonde (111 ; 811 ; 911) est représenté par

$$H_\alpha + jH_\beta \equiv H_0 \exp(j\varphi)$$

dans un plan complexe $\alpha\text{-}\beta$ qui est le plan de Gauss ;
l'amplitude du champ magnétique à la position de la sonde (111 ; 811 ; 911), Ho, est représentée par

$$H_0 \equiv (H_\alpha^2 + H_\beta^2)^{1/2}$$

qui est une distance à partir de l'origine dans le plan complexe $\alpha\text{-}\beta$;
la phase du champ magnétique à la position de la sonde (111 ; 811 ; 911), $\varphi$, est représentée par

$$\varphi \equiv \tan^{-1}(H_\beta / H_\alpha)$$

qui est un argument $\varphi$ dans le plan complexe $\alpha$-$\beta$ ;
la composante $\alpha$ du champ magnétique à la position de la sonde (111 ; 811 ; 911) est représentée par

$$H_\alpha = H_0 \cos \varphi$$

qui est une composante parallèle à l'axe $\alpha$ ; et où
la composante $\beta$ du champ magnétique à la position de la sonde (111 ; 811 ; 911) est représentée par

$$H_\beta = H_0 \cos \varphi$$

qui est une composante parallèle à l'axe $\beta$ perpendiculaire à l'axe $\alpha$,
le démodulateur (15) détecte le signal magnétique démodulé sous la forme (A) d'une paire de données constitué de la composante $\alpha$ et de la composante $\beta$ ($H_\alpha$, $H_\beta$) ou sous la forme (B) d'une paire de données constitué de l'amplitude et de la phase ($H_0$, $\varphi$).

3. Le dispositif de mesure de profil magnétique (1) d'après la revendication 2, sachant que
soit (X) la composante $\alpha$ est une composante de champ magnétique perpendiculaire du champ magnétique, sachant que la composante de champ magnétique perpendiculaire est une composante perpendiculaire à la surface de l'échantillon (5 ; 82 ; 93) ; et la composante $\beta$ est une composante de champ magnétique dans le plan du champ magnétique, sachant que la composante de champ magnétique dans le plan est une composante parallèle à la surface de l'échantillon (5 ; 82 ; 93),
ou (Y) la composante $\alpha$ est une composante de champ magnétique dans le plan du champ magnétique, sachant que la composante de champ magnétique dans le plan est une composante parallèle à la surface de l'échantillon (5 ; 82 ; 93) ; et la composante $\beta$ est une composante de champ magnétique perpendiculaire du champ magnétique, sachant que la composante de champ magnétique perpendiculaire est une composante perpendiculaire à la surface de l'échantillon (5 ; 82 ; 93).

4. Le dispositif de mesure de profil magnétique d'après la revendication 2 ou 3,
sachant que le champ magnétique à la position de la sonde (111 ; 811 ; 911) est affiché au moyen du dispositif d'affichage d'image (19) en transformant la composante $\alpha$ et/ou la composante $\beta$ en une image en fonction d'une variation de l'argument $\varphi$.

5. Un procédé pour mesurer un profil magnétique incluant le fait de balayer une zone de balayage sur une surface d'un échantillon (5 ; 82 ; 93) au moyen d'une sonde magnétisée (111 ; 811 ; 911) sur une pointe d'un élément en porte-à-faux entraîné (11 ; 81 ; 91), détecter des vibrations de l'élément en porte-à-faux (11 ; 81 ; 91) et générer une image de la distribution du champ magnétique de la zone de balayage basée sur les résultats de la détection, le procédé comprenant les étapes consistant à :

entraîner (S110) l'élément en porte-à-faux (11 ; 81 ; 91) à une fréquence de résonance de l'élément en porte-à-faux (11 ; 81 ; 91) ou à une fréquence proche de la fréquence de résonance de l'élément en porte-à-faux (11 ; 81 ; 91), sachant que la sonde (111 ; 811 ; 911) est équipée sur l'extrémité de l'élément en porte-à-faux (11 ; 81 ; 91);
générer (S120) un champ magnétique à courant alternatif, et inverser périodiquement la polarité magnétique de la sonde (111 ; 811 ; 911), et ainsi moduler la vibration entraînée de l'élément en porte-à-faux (11 ; 81 ; 91) par la fréquence ;
détecter (S130) des vibrations de la sonde (111 ; 811 ; 911) et démoduler à partir du signal de détection un signal magnétique qui correspond à une force magnétique alternée qui se produit entre la sonde (111 ; 811 ; 911) et l'échantillon (5 ; 82 ; 93) ;
détecter (S140) le signal magnétique démodulé sous la forme (A) de deux composantes de signal distinctes ayant une différence de phase de 90° et étant orthogonales l'une par rapport à l'autre, ou sous la forme (B) d'une amplitude et d'une phase du champ magnétique à la position de la sonde (111 ; 811 ; 911) ;
balayer (S150) la zone de balayage au moyen de la sonde (111 ; 811 ; 911) ;

stocker (S160) de données initiales dans une mémoire de données (17) pour chaque coordonnée de la zone de balayage, sachant que les données initiales sont (A) les deux composantes de signal distinctes et orthogonales l'une par rapport à l'autre ou (B) l'amplitude et la phase du champ magnétique, et sachant que les données initiales sont obtenues par balayage de la zone de balayage à condition que la démodulation soit synchronisée avec la génération du champ magnétique à courant alternatif ;
**caractérisé en ce que** le procédé comprend en outre les étapes consistant à :

rappeler (S170) les données initiales depuis la mémoire de données (17) et générer une pluralité de données en modifiant la phase des données initiales par une phase de correction $\varphi c$ ;
afficher (S180) une image d'une distribution de champ magnétique basée sur des données générées par la modification de la phase des données initiales, sur un dispositif d'affichage d'image (19) ; et à
mesurer (S190) le profil magnétique de l'échantillon (5 ; 82 ; 93) sur la base de chaque image de distribution de champ magnétique affichée sur le dispositif d'affichage d'image (19) ;
sachant que l'image de la distribution du champ magnétique est générée en attribuant la luminosité à l'intensité du champ magnétique, y compris la direction ; et que
la phase de correction $\varphi c$ qui ajuste la phase des données initiales à zéro est obtenue par le fait de :

modifier la phase de correction,
découvrir d'une image de distribution de champ magnétique ayant une luminosité maximale ou minimale,
utiliser un échantillon ayant un état de magnétisation connu, et de
ajuster la phase des données initiales à une position où uniquement un champ magnétique perpendiculaire ou à une position où seul un champ magnétique dans le plan se produit.

6. Le procédé pour mesurer un profil magnétique d'après la revendication 5, sachant que, dans l'étape consistant à détecter (S140) le signal magnétique démodulé,
où le champ magnétique à la position de la sonde (111 ; 811 ; 911) est représenté par

$$H_\alpha + jH_\beta \equiv H_0 \exp(j\varphi)$$

dans un plan complexe $\alpha$-$\beta$ qui est le plan de Gauss ;
l'amplitude du champ magnétique à la position de la sonde (111 ; 811 ; 911), Ho, est représentée par

$$H_0 \equiv (H_\alpha^2 + H_\beta^2)^{1/2}$$

qui est une distance à partir de l'origine dans le plan complexe $\alpha$-$\beta$ ;
la phase du champ magnétique à la position de la sonde (111 ; 811 ; 911), $\varphi$, est représentée par

$$\varphi \equiv \tan^{-1}(H_\beta / H_\alpha)$$

qui est un argument $\varphi$ dans le plan complexe $\alpha$-$\beta$ ;
la composante $\alpha$ du champ magnétique à la position de la sonde (111 ; 811 ; 911) est représentée par

$$H_\alpha = H_0 \cos \varphi$$

qui est une composante parallèle à l'axe $\alpha$ ; et où
la composante $\beta$ du champ magnétique à la position de la sonde (111 ; 811 ; 911) est représentée par

$$H_\beta = H_0 \cos \varphi$$

qui est une composante parallèle à l'axe $\beta$ perpendiculaire à l'axe $\alpha$,
le signal magnétique démodulé est détecté sous la forme (A) d'une paire de données constitué de la composante α et de la composante β ($H_α$, $H_β$) ou sous la forme (B) d'une paire de données constitué de l'amplitude et de la phase ($H_0$, φ).

**7.** Le procédé pour mesurer un profil magnétique d'après la revendication 6, sachant que

soit (X) la composante α est une composante de champ magnétique perpendiculaire du champ magnétique, sachant que la composante de champ magnétique perpendiculaire est une composante perpendiculaire à la surface de l'échantillon (5 ; 82 ; 93) ; et la composante β est une composante de champ magnétique dans le plan du champ magnétique, sachant que la composante de champ magnétique dans le plan est une composante parallèle à la surface de l'échantillon (5 ; 82 ; 93),

ou (Y) la composante α est une composante de champ magnétique dans le plan du champ magnétique, sachant que la composante de champ magnétique dans le plan est une composante parallèle à la surface de l'échantillon (5 ; 82 ; 93) ; et la composante β est une composante de champ magnétique perpendiculaire du champ magnétique, sachant que la composante de champ magnétique perpendiculaire est une composante perpendiculaire à la surface de l'échantillon (5 ; 82 ; 93).

**8.** Le procédé pour mesurer un profil magnétique d'après la revendication 6 ou 7,
sachant que le champ magnétique à la position de la sonde (111 ; 811 ; 911) est affiché au moyen du dispositif d'affichage d'image (19) en transformant la composante α et/ou la composante β en une image en fonction d'une variation de l'argument φ.

Fig. 1

# Fig. 2

START

S110

Drive a probe magnetization polarity alternation coil and drive a cantilever at a resonant frequency of the cantilever or at a frequency close to the resonant frequency of the cantilever

S120

Modulate driven vibration of the cantilever by frequency

S150

Scan a scanning area on a surface of the specimen by means of the probe

S130

Detect vibration of the prove, and demodulate from the detection signal a magnetic signal corresponding to alternating magnetic force between the probe and the specimen

S140

Detect amplitude and a phase of magnetic field at the position of the probe from the demodulated magnetic signal

S160

Store the amplitude and the phase of the magnetic field for each coordinate of the scanning area as an initial data in a data storage

S170

Recall the initial data from the data storage, and generate a plurality of data by modifying the phase of the initial data

S180

Display images of magnetic field distribution for each coordinate of the scanning area based on the data in which the phase of the initial data is modified

S190

Obtain a magnetic profile of the specimen (magnetic state) by observing the images of magnetic field distribution

END

Fig. 3

Fig. 4A

Fig. 4B

Fig. 5A

Fig. 5B

Fig. 6

| 4.5 (0) | 34.5 (30) | 64.5 (60) | 94.5 (90) | 124.5 (120) | 154.5 (150) |
| 184.5(180) | 214.5(210) | 244.5(240) | 274.5(270) | 304.5(300) | 334.5(330) |

Fig. 7

81

82

811

812

Fig. 8

## Fig. 9A

## Fig. 9B

**EP 2 762 896 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003065935 A
- WO 2009101991 A
- US 20110030109 A1

- JP 4769918 B
- EP 2613160 A1
- EP 1830172 A2

**Non-patent literature cited in the description**

- **SAITO HITOSHI et al.** Direction detectable static magnetic field imaging by frequency-modulated magnetic force microscopy with an AC magnetic field driven soft magnetic tip. *Journal of Applied Physics,* 06 April 2011, vol. 109 (7